Europäisches Patentamt

(19) European Patent Office

Office européen des brevets

(11) **EP 0 823 662 A2**

(12) **EUROPEAN PATENT APPLICATION**

(43) Date of publication:
11.02.1998 Bulletin 1998/07

(51) Int. Cl.⁶: $G03F\ 7/20$, $G03F\ 9/00$

(21) Application number: 97113696.5

(22) Date of filing: 07.08.1997

(84) Designated Contracting States:
AT BE CH DE DK ES FI FR GB GR IE IT LI LU MC
NL PT SE

(30) Priority: 07.08.1996 JP 208260/96
22.08.1996 JP 221261/96
04.09.1996 JP 234158/96

(71) Applicant: NIKON CORPORATION
Tokyo 100 (JP)

(72) Inventors:
• Hashimoto, Sumio,
c/o Nikon Corporation
Chiyoda-ku, Tokyo (JP)

• Mori, Takashi,
c/o Nikon Corporation
Chiyoda-ku, Tokyo (JP)
• Kudo, Shintaro,
c/o Nikon Corporation
Chiyoda-ku, Tokyo (JP)

(74) Representative:
Ritter und Edler von Fischern, Bernhard, Dipl.-
Ing. et al
Hoffmann Eitle,
Patent- und Rechtsanwälte,
Arabellastrasse 4
81925 München (DE)

(54) **Projection exposure apparatus**

(57) A projection exposure apparatus for transferring the image of a mask pattern on a mask onto a photosensitive substrate by an exposing radiation flux is provided. The projection exposure apparatus includes a projection optical system including at least one lens and having a predetermined optical axis, and a first illumination system for directing the exposing radiation flux that is capable of exposing the photosensitive substrate toward the mask to illuminate the mask pattern, the exposing radiation flux that has passed through the mask entering the projection optical system and illuminating the at least one lens, a thus illuminated portion of the at least one lens having rotational asymmetry around the predetermined optical axis, the exposing radiation flux that has passed through the at least one lens exposing the image of the mask pattern onto the photosensitive substrate. The projection exposure apparatus according to the present invention further includes a second illumination system for directing a non-exposing radiation flux that is incapable of exposing the photosensitive substrate toward the projection optical system, the non-exposing radiation flux illuminating the at least one lens in the projection optical system to complement the portion illuminated by the exposing radiation flux such that the resultant illuminated portions on the at least one lens have substantial rotational symmetry around the predetermined optical axis of the projection optical system as a whole.

FIG. 1A

## Description

This application claims the benefit of Japanese applications, No. 08-208260, filed on August 7, 1996, No. 08-221261, filed on August 22, 1996, No. 08-234158, filed on September 4, 1996, all of which are hereby incorporated by reference.

### BACKGROUND OF THE INVENTION

#### Field of the Invention

The present invention relates to an exposure apparatus, and more particularly, to a projection exposure apparatus for exposing a mask pattern on a mask onto a photosensitive substrate in the photolithography processes for manufacturing semiconductor devices, liquid crystal devices, image pick up devices (e.g. CCD) or thin film magnetic heads, etc.

#### Discussion of the Related Art

In manufacture of semiconductor devices or the like, a projection exposure apparatus, such as a stepper, etc., of conventional technology has been widely used. The exposure apparatus is capable of exposing a whole pattern of a reticle mask (or mask etc.) via a projection optical system onto a square-like illumination region on a wafer or a photosensitive substrate (glass substrate, for example), which is coated with photoresist. To meet a recent demand for larger chip patterns used in semiconductor devices etc., a technique, in which a larger reticle pattern can be transcribed onto each of the shot regions is required. However, it is difficult to design and manufacture a projection optical system that can suppress aberrations, such as distortion and deformation of the image plane, over the entire effective exposure field (field of view) of such a large area within a given tolerance.

For this reason, a projection exposure apparatus employing a step-and-scan scheme has become popular. In the step-and-scan projection exposure apparatus, the mask and the wafer are synchronously moved with respect to the optical system to successively project and transcribe a pattern in a slit-like region onto the wafer. This step-and-scan projection exposure apparatus can maximumly utilize the effective exposure field diameter. Also, the length of the pattern being transcribed in the scanning direction can be longer than the diameter of the effective exposure field. As a result, a larger reticle pattern can be transcribed on a wafer with sufficiently small aberrations.

In general, in projection exposure apparatus, a high power illumination light is emitted to lenses in the projection optical system during exposure. The energy absorption rate of the glass material, by which the lenses in the projection optical system are made of, is as little as 0.2%/cm, for example. If illumination light illuminates one of the lenses asymmetrically around the optical axis, the lens asymmetrically absorbs the emission energy of light and accordingly acquires an asymmetric temperature distribution. This causes asymmetrical thermal distortion on the lens. Also, the local temperature fluctuation changes the index of refraction of the glass material. Because of this, the characteristics of aberrations in the projection optical system may gradually change over time. Such aberration fluctuations cannot be accepted in view of the recent stringent specification required for a projection optical system.

In the projection optical system of conventional technology, these aberrations are corrected by dividing the projection optical system, for example, into three scaled blocks and controlling the pressure of the air surrounding the lenses inside each of the blocks. When this technique is used in the exposure apparatus, in which the entire mask is exposed with a square-shape illumination area at a time, as in a stepper, since the rotational asymmetry of the square is not too large, the fluctuations in aberrations can be corrected to an excellent degree. However, when using the illumination region that is strongly asymmetric around the optical axis, such as a rectangular or arc shape, etc., as in the scanning projection exposure apparatus, such pressure control can not sufficiently suppress the fluctuations in the aberrations (such as distortion or deformation of the image plane, etc.) within a predetermine tolerance. Particularly, with strong asymmetry, astigmatism occurs in the center of the exposure field of the projection optical system. That is, the best image plane of the pattern in the meridional direction and the best image plane of the pattern in a direction perpendicular to the meridional direction are separated along the optical axial direction.

Another aspect of the related art is as follows. In the projection exposure systems, in general, considerable amount of effort has been devoted to development of a projection exposure apparatus that is capable of using the shortest possible wavelength exposure light for mask illumination and making the numerical aperture (NA) of the projection optics as large as possible to improve the resolution of the transferred pattern image, which is necessary for exposing circuit patterns of higher integration onto the wafers,.

Simply increasing the numerical aperture of the projection optics, however, reduces the depth of focus. A demand for a method of improving the resolution without increasing the numerical aperture has led to the development of a new illumination technique, in which the exposure light is obliquely directed toward the reticle. This technique provides higher resolution, while at the same time securing some minimum depth of focus. In this illumination technique, the secondary light source in the illumination optical system may be annularly shaped ("annular illumination") or composed of a plurality of (four, for example) small light sources each being eccentric with respect to the optical axis ("modified illumination"). With such illumination techniques, the resolution of the projection optical system can be improved without decreasing the wavelength of the exposure light or increasing the numerical aperture. A method called "super resolution" has also been developed. This method improves the resolution by placing a pupil filter having a ring shape, etc., at the pupil surface of the projection optical system.

When the reticle is illuminated by illumination light that has a uniform intensity distribution with respect to a center light ray which is vertically incident on the reticle (i.e., not annular or modified illumination), the image of the pattern on the wafer is formed mainly by three light rays: the 0th, +1st, and -1st order diffraction light rays, that have passed through the reticle pattern. Thus, the entire surface of a lens that is located in the vicinity of the pupil surface of the optical system is illuminated with uniform intensity: the intensity at the center of the lens is the same as that of the periphery. Also, when using a standard illumination method where no annular pupil filter for blocking light in its center is placed at the pupil surface of the projection optical system, a lens in the vicinity of the pupil surface of the projection optical system is evenly illuminated. In this uniform illumination condition, since the temperature rises mainly near the center of the lens, the resultant thermal distortion and fluctuations in the index of refraction can be represented by a quadratic or lower order function of the position in the lens. Therefore, fluctuations in aberrations occur mainly as a form of a positional shift of the Gauss image plane in the vicinity of the optical axis. In other words, fluctuations in the higher order spherical aberrations do not occur under such a uniform illumination condition.

When illumination is performed using the annular illumination or modified illumination method above, the image of the reticle pattern is formed on the wafer mainly by the +1st and - 1st order diffraction light beams that are generated by interaction of the exposing illumination light with the reticle pattern. Therefore, if a large portion of the reticle pattern has the minimum line width, i.e., requires the maximum resolution of the projection optical system, the amount of the light flux that propagates near the optical axis of the projection optical system is extremely small as compared with the amount of the light flux passing in the periphery.

When a pupil filter is placed at the pupil surface of the projection optical system to block light near the optical axis, the amount of the light flux that illuminates lenses located after the pupil filter near the optical axis of the projection optical system is also extremely small as compared with the amount of the light flux passing in the periphery of the lenses.

When the illumination energy is unevenly distributed over a lens in the projection optical system in this manner, the temperature around the periphery of the lens rises due to heat absorption, while the temperatures at the center of the lens do not rise so much. Local fluctuations in the index of refraction of the lens and thermal deformation (or distortion) occur as a result of such a temperature distribution. This, in turn, results in the formation of a 2nd or higher order aspherical surface in the lens and the corresponding changes in the index of refraction. Therefore, in the vicinity of the optical axis of the projection optical system, not only the Gauss image plane shift but also changes in high order spherical aberrations occurs.

## SUMMARY OF THE INVENTION

Accordingly, the present invention is directed to a projection exposure apparatus that substantially obviates the problems due to limitations and disadvantages of the related art.

An object of the present invention is to provide a projection exposure apparatus that is capable of suppressing fluctuations in aberrations of the projection optical system when transcribing a pattern in an asymmetrical-shaped illumination area on a reticle via a projection optical system.

Another object of the present invention is to provide a projection exposure apparatus that is capable of suppressing fluctuations in high-order spherical aberrations of the projection optical system when exposure is performed using an annular or modified illumination method, and/or using a pupil filter to block light near the optical axis.

Additional features and advantages of the invention will be set forth in the description that follows, and in part will be apparent from the description, or may be learned by practice of the invention. The objectives and other advantages of the invention will be realized and attained by the structure particularly pointed out in the written description and claims hereof as well as the appended drawings.

To achieve these and other advantages and in accordance with the purpose of the present invention, as embodied and broadly described, the present invention provide, a projection exposure apparatus for transferring the image of a mask pattern on a mask onto a photosensitive substrate by an exposing radiation flux, the projection exposure apparatus including a projection optical system including at least one lens and having a predetermined optical axis; a first illumination system for directing the exposing radiation flux that is capable of exposing the photosensitive substrate toward the mask to illuminate the mask pattern, the exposing radiation flux that has passed through the mask entering the projection optical system and illuminating the at least one lens, a thus illuminated portion of the at least one lens having rotational asymmetry around the predetermined optical axis, the exposing radiation flux that has passed through the at least one lens exposing the image of the mask pattern onto the photosensitive substrate; and a second illumination system for directing a non-exposing radiation flux that is incapable of exposing the photosensitive substrate toward the projection optical system, the non-exposing radiation flux illuminating the at least one lens in the projection optical system to complement tile portion illuminated by the exposing radiation flux such that the resultant illuminated portions on the at least one lens have substantial rotational symmetry around the predetermined optical axis of the projection optical system as a whole.

In another aspect, the present invention provides a projection exposure apparatus for transferring the image of a mask pattern on a mask onto a photosensitive substrate, the projection exposure apparatus including a projection optical system for projecting the image of the mask pattern on the mask onto the photosensitive substrate, the projection optical system including at least one lens and having a predetermined optical axis; a first light source for emitting first illumination light that is capable of exposing the photosensitive substrate; a second light source for emitting second illumination light that is incapable of exposing the photosensitive substrate; a combining system for combining the first illumination light and the second illumination light and directing the combined light toward the mask; and a field stop disposed on an optical path between the combining system and the mask at a position substantially conjugate with a patterned surface of the mask, the field stop including a first transmissive portion for selectively transmitting the first illumination light and a second transmissive portion for selectively transmitting the second illumination light, the first illumination light that has passed through the first transmissive portion entering the projection optical system through the mask to illuminate the at least one lens in the projection optical system, a thus illuminated portion of the at least one lens having rotational asymmetry around the predetermined optical axis of the projection optical system, the first illumination light that has passed through the at least one lens exposing the image of the mask pattern onto the photosensitive substrate, the second illumination light that has passed through the second transmissive portion entering the projection optical system through the mask to illuminate the at least one lens to complement the portion illuminated by the first illumination light such that the resultant illuminated portions of the at least one lens have substantial rotational symmetry around the predetermined optical axis of the projection optical system as a whole.

In another aspect, the present invention provides a projection exposure apparatus for transferring the image of a mask pattern on a mask onto a photosensitive substrate by an exposing radiation flux, the projection exposure apparatus including a projection optical system having a predetermined optical axis, for projecting the image of the mask pattern onto the photosensitive substrate; an illumination optical system for directing the exposing radiation flux toward the mask, the exposing radiation flux that has passed through the mask entering the projection optical system with a cross-section substantially circular around the predetermined optical axis; and a light control member disposed between the projection optical system and the photosensitive substrate, the light control member including a transmissive portion for selectively transmitting the exposing radiation flux from the projection optical system, the exposing radiation flux that has passed through the transmissive portion having a cross-section substantially rotationally asymmetric around the predetermined optical axis of the projection optical system.

In another aspect, the present invention provides a projection exposure apparatus for projecting the image of a mask pattern on a mask onto a photosensitive substrate by an exposing radiation flux, including a projection optical system having an optical axis and a pupil surface; an illumination optical system for directing the exposing radiation flux toward the mask, the exposing radiation flux that has passed through the mask entering the projection optical system and passing through portions on the pupil surface that are distributed to exclude an area including the optical axis of the projection optical system; and an auxiliary optical system for directing a non-exposing radiation flux that is incapable of exposing the photosensitive substrate toward the remaining portions on the pupil surface excluding the portions which the exposing radiation passes through.

In another aspect, the present invention provides a projection exposure apparatus for projecting the image of a mask pattern on a mask onto a photosensitive substrate by an exposing radiation flux, including a projection optical system having an optical axis and a pupil surface; a combining illumination optical system for directing the exposing radiation flux that is capable of exposing the photosensitive substrate and a non-exposing radiation flux that is incapable of exposing the photosensitive substrate toward the pupil surface of the projection optical system, the exposing radiation flux passing through portions on the pupil surface that are distributed to exclude an area including the optical axis of the projection optical system; and an optical member for selectively directing toward the photosensitive substrate the non-exposing radiation flux that passes through the remaining portions of the pupil surface.

In another aspect, the present invention provides a projection exposure apparatus using a portion of an exposing radiation flux that is obliquely incident on or obliquely emitted from a mask as effective exposing light to expose a photosensitive subsirate, the projection exposure apparatus including a projection optical system for projecting the image of a mask pattern on the mask onto the photosensitive substrate with the exposing radiation flux, the projection optical system having an pupil surface and an optical axis; an illumination optical system for illuminating the mask using the exposing radiation flux from a plurality of light sources, which are substantially uniformly distributed over an circular region around the optical axis at a surface conjugate with the pupil surface of the projection optical system; a first polarization member disposed at at least one of the pupil surface of the projection optical system and a surface conjugate with the pupil surface, the first polarization member polarizing the remaining exposing radiation flux excluding said

4

effective exposing radiation flux in a predetermined direction; and a second polarization member disposed between the projection optical system and the photosensitive substrate, the second polarization member blocking the exposing radiation flux that has been polarized in the predetermined direction by the first polarization member and passed through the projection optical system.

In a further aspect, the present invention provides a method of suppressing non-uniform illumination distribution on a lens in a projection optical system used in a projection exposure apparatus for projecting the image of a mask pattern on a mask onto a photosensitive substrate through the projection optical system, the method including the steps of directing the exposing radiation flux that is capable of exposing the photosensitive substrate toward the mask; guiding the exposing radiation flux that has passed through the mask toward the projection optical system, the exposing radiation flux illuminating a portion on the lens in the projection optical system; directing a complementary radiation flux toward the lens to illuminate a substantially remaining portion on the lens; and transferring the image of the mask pattern onto the photosensitive substrate with the exposing radiation flux that has illuminated the portion of the lens in the step of guiding.

It is to be understood that both the foregoing general description and the following detailed description are exemplary and explanatory and are intended to provide further explanation of the invention as claimed.


## BRIEF DESCRIPTION OF THE DRAWINGS

The accompanying drawings, which are included to provide a further understanding of the invention and are incorporated in and constitute a part of this specification, illustrate embodiments of the invention and together with the description serve to explain the principles of the invention.

In the drawings:

FIG. 1A schematically shows a projection exposure apparatus according to a first example of a first preferred embodiment of the present invention;

FIG. 1B is a partial plan view of a reticle showing an illumination region thereon according to the projection exposure apparatus of FIG. 1A;

FIG. 1C is a partial plan view of a wafer showing an illumination region thereon according to the projection exposure apparatus of FIG. 1A;

FIG. 2A schematically shows a projection exposure apparatus according to a second example of the first preferred embodiment of the present invention;

FIG. 2B is a plan view of a field stop for the projection exposure apparatus of FIG. 2A;

FIG. 2C is a plan view of an alternative field stop for the projection exposure apparatus of FIG. 2A;

FIG. 3A is a plan view showing the illumination region on a lens for use in a first calculation example to demonstrate the effects of the aberration improvement provided by the preferred embodiment of the present invention shown in FIGs. 1A to 1C;

FIG. 3B is a diagram showing the results of calculating the temperature distribution on the lens after temperature rises;

FIG. 4A is a plan view showing the illumination region on the lens used in the first calculation example;

FIG. 4B is a diagram showing the results of calculating the temperature distribution on the lens after temperature rises;

FIG. 5A is a plan view showing the illumination region on a lens used in a second calculation example to demonstrate the effects of the aberration improvement provided by the first preferred embodiment of the present invention shown in FIG. 1,

FIG. 5B is a diagram showing the results of calculating the temperature distribution on the lens after temperature rises;

FIG. 6A is a plan view showing the illumination region on the lens for used in the second calculation example;

FIG. 6B is a diagram showing the results of calculating the temperature distribution on the lens after temperature rises;

FIG. 7A is a schematic diagram showing a modification of the first example of the first embodiment of the present invention;

FIG. 7B shows the illumination region on the reticle 4 held in the projection exposure apparatus of FIG. 7A;

FIG. 8A is a schematic diagram showing a projection exposure apparatus the third example of the first preferred embodiment of the present invention;

FIG. 8B is a plan view of the light-shielding plate of the projection exposure apparatus of FIG. 8A;

FIG. 9A is a diagram showing a condition where the illumination light is bent by the light-shielding plate when there is a space between the light-shielding plate and a wafer in the example of FIG. 8A;

FIG. 9B schematically shows an example of a member, which can be placed on the reticle or at a position having a conjugate relationship with the reticle in the case of FIG. 9A;

FIG. 10 is a schematic view showing the configuration of a projection exposure apparatus according to a first example of a second preferred embodiment of the present invention;

FIGs. 11A, 11B, and 11C are enlarged plan views of various aperture stops to be provided at the light source unit of FIG. 10.

FIG. 12A is a plan view of a guiding mirror 205 of FIG. 10, as viewed from the reticle side;

FIG. 12B is a plan view of an alternative guiding mirror 205A, as viewed from the reticle side;

FIG. 13 is a schematic view showing the configuration of a modified version of the first example of the second preferred embodiment of the present invention;

FIG. 14A is a plan view of an aperture stop 237 for the projection exposure apparatus of FIG. 13;

FIG. 14B is a plan view of an alternative aperture stop 237A for the projection exposure apparatus of FIG. 13;

FIG. 15 is a simplified schematic diagram showing the configuration of an exposure apparatus according to a second example of the second preferred embodiment of the present invention;

FIG. 16 is a simplified schematic diagram showing the configuration of an exposure apparatus according to a modified version of the second example of FIG. 15;

FIGs. 17A, 17B, and 17C are graphs illustrating examples of computation of temperature distribution due to illumination energy according to the second embodiment of the present invention;

FIG. 18 is a perspective view schematically showing a projection exposure apparatus according to a third preferred embodiment of the present invention;

FIGs. 19A, 19B, and 19C are plan views of various aperture stops provided in the light source unit of the projection exposure apparatus of FIG. 18;

FIG. 20A is a plan view showing partial polarization plate 310 for the projection exposure apparatus of FIG. 18;

FIG. 20B is a plan view showing partial polarization plate 310A for a modified illumination method for use in the projection exposure apparatus of FIG. 18;

FIG. 20C is a plan view showing another example of the partial polarization plate of FIG. 20B; and

FIG. 21 is a perspective view schematically showing the major parts of a projection exposure apparatus according to another example of the third preferred embodiment of the present invention.

## DETAILED DESCRIPTION OF THE PREFERRED EMBODIMENTS

Reference will now be made in detail to the preferred embodiments of the present invention, examples of which are illustrated in the accompanying drawings.

## First Preferred Embodiment

### First example

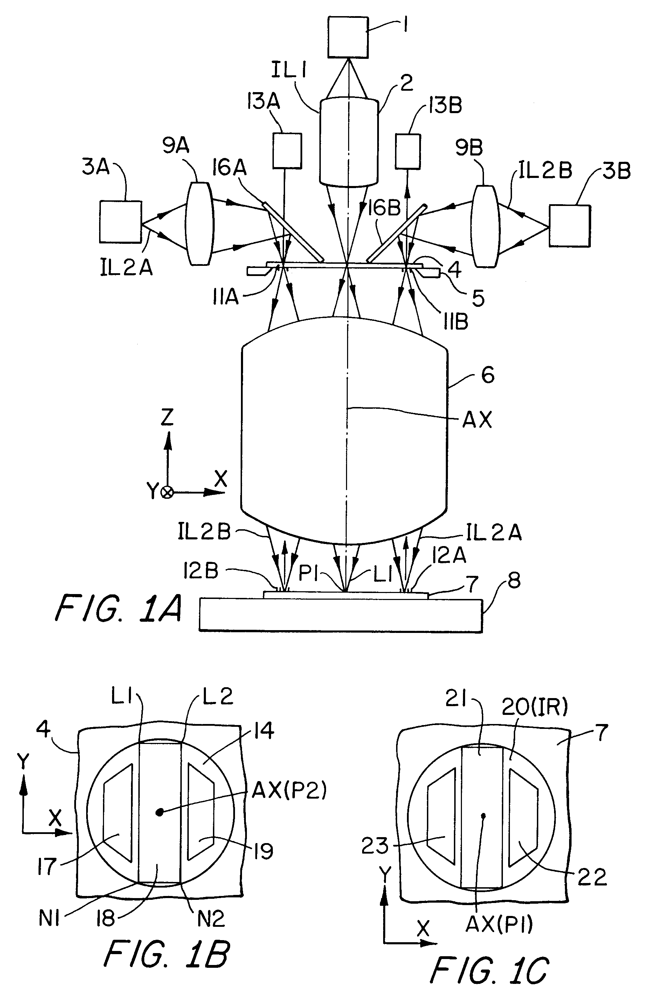

A first example of a first preferred embodiment according to the present invention is described by referring to FIGs. 1A to 1C. This embodiment applies the present invention to a step-and-scan projection exposure apparatus.

FIG. 1A schematically shows the configuration of a projection exposure apparatus according to the present example. As shown in FIG. 1A, the projection exposure apparatus is equipped with light sources 1, 3A, and 3B, which illuminate a pattern region of reticle 4. During exposure, the light source 1 emits illumination light IL1 having wavelength $\lambda 1$ which is sensitive to a photoresist coated on wafer 7 (photosensitive or exposing wavelength). The light sources 3A, 3B emit illumination light IL2A, IL2B having non-photosensitive (or non-exposing) wavelength $\lambda 2$ with respect to the photoresist coated on wafer 7. The light source 1 includes a fly-eye lens, which uniformly distributes the illumination beam onto reticle 4, and a field stop which defines an illumination region on reticle 4, etc. The illumination light IL1 emitted from the light source 1 passes through an illumination optical system 2 and forms on the reticle 4 a rectangular illumination region 18 (FIG. 1B) extending in the non-scanning direction. Under the illumination light IL1, the image of the pattern in the rectangular illumination region 18 on a reticle 4 is transferred onto the photoresist coated on the wafer 7 via a projection optical system 6 at a projection magnification $\beta$ (e.g. $\beta = 1/4$ or $1/5$). In FIG. 1A, the Z axis is taken parallel to the optical axis AX of the projection optical system 6, the X axis is taken in the two dimensional plane of the paper of FIG. 1A and perpendicular to the Z axis, and the Y axis is taken normal to FIG. 1A. The X direction is the scanning (or moving) direction of reticle 4 and wafer 7.

Each of the non-exposure light sources 3A, 3B includes a fly-eye lens for uniformly distributing the illumination beam onto reticle 4 and a field stop for defining an illumination region on the reticle 4, etc. The light source 3A, which is placed above the reticle 4 at the - X direction side, emits the illumination light IL2A of the wavelength $\lambda 2$. The illumination light IL2A passes through a condenser lens 9A and is reflected by a mirror 16A, which has a small transmissivity and is obliquely placed with respect to the incoming direction of the illumination light IL2A to form an illumination region 17 on the reticle 4 (FIG. 1B). The light source 3B emits the illumination light IL2B of the wavelength $\lambda 2$. The illumination light IL2B passes through a condenser lens 9B and is reflected by a mirror 16B, which has a small transmissivity and is obliquely placed with respect to the incoming direction of the illumination light IL2B to form an illumination region 19 on the reticle 4 (FIG. 1B). The illumination light fluxes IL2A, IL2B that pass through the reticle 4 is directed toward the surface of the wafer 7 via the projection optical system 6.

In this example, the illumination region 17 formed by the illumination light IL2A and the illumination region 19 formed by the illumination light IL2B are disposed on the reticle 4 along the scanning direction (X direction) on the both sides of the rectangular illumination region 18 formed by the illumination light IL1.

The wavelength $\lambda 1$ of the illumination light IL1 and the wavelength $\lambda 2$ of the illumination light IL2B are chosen in accordance with the type of the photoresist and the glass material of which the projection optical system 6 is made. For example, the wavelength $\lambda 1$ is less than 530nm, and for the wavelength $\lambda 2$ is equal to or larger than 530nm. As the illumination light IL1 for exposure, the emission lines of a mercury lamp, such as the i-line (wavelength=365nm) or the g-line (wavelength =436nm), excimer laser light (ArF excimer laser, wavelength=193nm or KrF excimer laser wavelength=248nm), or the harmonics of a laser beam from a copper vapor laser or a YAG laser, etc. may be used.

Illumination light fluxes IL2A, IL2B are used to form a uniform distribution of thermal energy in the lens of the projection optical system (i.e., to suppress rotationally asymmetrical distribution of thermal energy). Therefore, it is preferable to use the illumination light for IL2A, IL2B that is absorbed by a coating film on the lens and the glass material as a whole by substantially the same amount per unit area as the exposing light IL1. One of the preferable factors for the illumination light beams IL2A, IL2B in addition to having the non-exposing wavelength is to have enough intensity when the absorption rate in the lens is small or to have large absorption rate if the intensity is small. An example of such illumination light is the laser beam of the He-Ne laser (wavelength 633nm).

Quartz or glass, etc., may be used as a glass material for the projection optical system. Such glass materials have a considerable light absorption rate even at a wavelength equal to or larger than $2\mu m$. Therefore, an HF chemical laser beam, etc., (wavelength 2.4 to $3.4\mu m$) can be used for the illumination light beams IL2A, IL2B. Optical glasses other than one made of quartz usually includes impurities therein. Because of this, some of them have the light absorption rate close to 1%/cm with respect to light having a wavelength equal to or larger than 530 nm. Even such illumination light (having light absorption ratio about 1%/cm) can effectively suppress rotational asymmetry in distribution of the thermal energy. Examples of such light are the C-line (wavelength 656.3nm) of a hydrogen discharge tube or the d-line (wavelength 587.6nm) of a helium discharge tube, etc.

The reticle 4 is held on a reticle stage 5. The reticle stage 5 is movable in the scanning direction (X direction) at a constant speed, and also the position of the reticle stage 5 is finely adjustable in the X and Y directions. Externally installed interferometers (not illustrated) measure the position of the reticle stage 5 with high accuracy. The position of the reticle stage 5 is then controlled in accordance with the values measured at the interferometers. In addition, reticle marks 11A, 11B are formed on the reticle 4 for use in alignment of reticle 4 with wafer 7.

The wafer 7 is held on a wafer stage 8. The wafer stage 8 is movable at a constant speed in the scanning direction (X direction) via a wafer holder (not illustrated). The wafer stage 8 can move stepwise in the X and Y directions such that the image of the reticle 4 pattern is sequentially transferred onto each of the shot regions on the wafer 7 by the step-and-scan mode. In the step-and-scan mode, a shot region is moved to the scan-stating position with respect to the exposure region of the projection optical system 6 and is scanned by the exposing light. This operation is performed on each shot region. During the scan-exposure, if the reticle 4 is moved in the +X direction (or -X direction) at a speed $V_R$, with respect to the exposing light, the wafer 7 is moved in the -X direction (or +X direction) at a speed $\beta \cdot Vg$ ($\beta$ is the projection magnification of the optical system 6) in synchronization with the reticle movement. Also, wafer marks 12A, 12B are formed in each shot region of the wafer 7 for use in alignment.

Exposure operation according to the present example is described next. During the scan-exposure, the projection exposure apparatus of the present example illuminates not only the slit-like illumination region on the reticle 4 but also other reticle pattern regions. That is, during the scan-exposure, three light sources 1, 3A, 3B emit illumination light beams IL1, IL2A, and IL2B simultaneously.

FIG. 1B shows various regions on reticle 4 illuminated by the illumination light beams IL1, IL2A, IL2B. In FIG. 1B, the illumination light IL1 from the light source 1 illuminates a rectangular illumination region 18 defined by points L1, L2, N2, and N1. The rectangular illumination region 18 circumscribes the circular boundary of a round-shape effective illumination region 14, which is conjugate with the effective exposure field (field of view) of the projection optical system 6. In this case, the center P2 of the round-shape effective illumination region 14 coincides with the optical axis AX.

The illumination light IL2A from the light source 3A forms the trapezoidal illumination region 17 on the -X direction side of the illumination region 18 (left of the border line defined by points L1 and N1 in FIG. 1B). The illumination light IL2B from the light source 3B forms the trapezoidal illumination region 17 on the + X direction side of the illumination region 18 (right of the border line defined by points L2 and N2). As shown in FIG. 1B, the illumination regions 17, 19 serve as complementary elements to the rectangular illumination region 18 for forming an illumination area that has high rotational symmetry as a whole. That is, the illumination regions 17,19 along with the rectangular illumination region 18 form an illumination region which is close to the annular effective illumination region 14. The illumination light IL1 that passes through the illumination region 18, and illumination light beams IL2A, IL2B that pass through the illumination regions 17, 19, respectively, are guided toward the wafer 7 through the projection optical system 6.

FIG. 1C shows various illumination regions formed on the wafer 7. In FIG. 1C, the illumination light IL1 illuminates a rectangular exposure region 21 on the wafer 7 and exposes the photoresist on the wafer 7. The rectangular exposure region 21 is longer in the non-scanning direction (Y direction) and circumscribes the circular boundary of a round-shape effective exposure region 20, which is conjugate with the effective exposure field (field of view) of the projection optical system 6. In this case, the center P1 of the annular effective exposure region 20 coincides with the optical axis AX. Also, illumination light beams IL2A, IL2B, which do not expose the photoresist on the wafer 7, are directed toward the wafer 7 to form illumination regions 22, 23, respectively. The illumination regions 22, 13 along with the rectangular exposure region 21 form around-like illumination region corresponding to the circular effective exposure region 20.

Therefore, during the scan-exposure operation, the illuminated regions on the reticle have relatively high rotational symmetry as a whole, and the lenses in the projection optical system 6 are also illuminated in a rotationally symmetric manner. As a result, energy density distribution in the glass material for the lens, which is generated by absorbing a portion of the illumination light, has relatively high rotational symmetry. Therefore, rotationally asymmetrical thermal distortion in the projection optical system 6 can be reduced, and accordingly, fluctuations in aberrations in the projection optical system 6 can be reduced. In this case, in order to effectively reduce the aberration fluctuations, it is preferable that the total area of illumination regions 17, 19 on the reticle 4 formed by the illumination light beams IL2A, IL2B from the light sources 3A, 3B is equal to or greater than the half of the area of the effective illumination region 14 excluding the illumination region 18.

The illumination light beams IL2A, IL2B, which are transmitted through the illumination regions 17, 19, illuminate the illumination regions 22, 23 on the wafer 7, respectively. Nonetheless, since the illumination light beams IL2A, IL2B does not expose the photoresist on the wafer 7, only the image of the pattern within the illumination region 18 on the reticle 4 is transferred onto the photoresist on the wafer 7.

In addition, in this example, the illumination light beams IL2A, IL2B from the light sources 3A, 3B can also be used as alignment sensor light beams for aligning the reticle 4 with the wafer 7. As shown in FIG. 1A, alignment sensors 13A, 13B of TTR (through-the-reticle) image processing type are arranged above the reticle 4, and the illumination light beams IL2A, IL2B are directed toward regions on the reticle 4 at which the reticle marks 11A, 11B are formed. Then, using the alignment sensors 13A, 13B, the positional deviations of the wafer marks 12A, 12B relative to the reticle marks 11A, 11B are detected. In this case, a separate light source is not required for the alignment sensors. The alignment sensors 13A, 13B may detect the reticle marks 11A, 11B and wafer marks 12A, 12B separately.

In this example (and in the following examples), the second illumination light (IL2A, IL2B) needs to be absorbed in the lens glass material which construct the projection optical system 6 to some extent. However, it can be absorbed in the lens coating layer instead of the lens glass material.

**Modified first example**

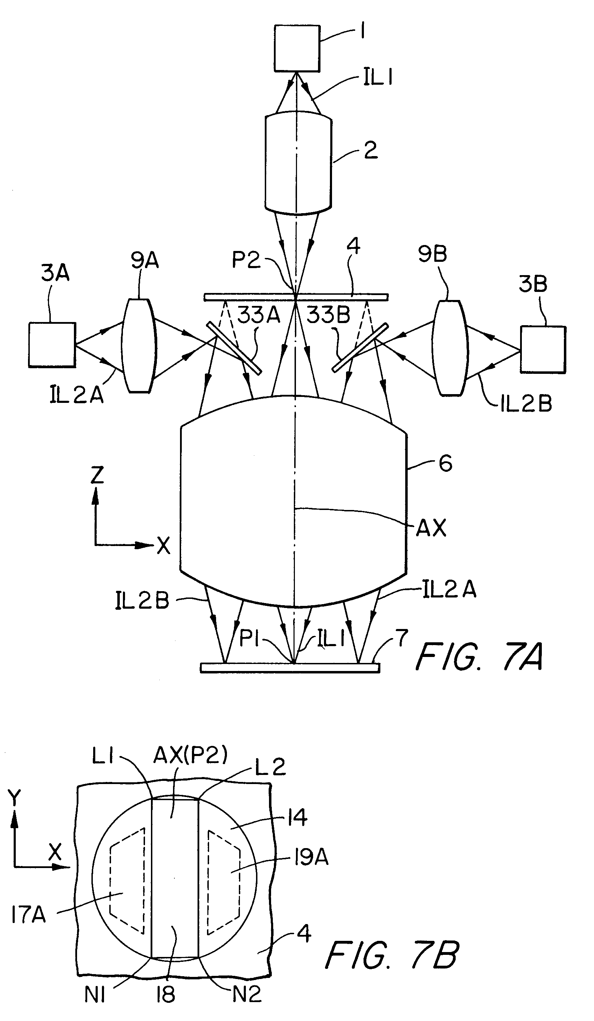

Next, a modification of the first example of the first preferred embodiment above is described with reference to FIGs. 7A and 7B. In this example, the illumination light beams IL2A, iL2B from the light sources 3A, 3B enters the projection optical system 6 without passing through the reticle 4. The other configuration remains the same as in the first example. In FIGs. 7A and 7B, the same components as those of FIGS. 1A to 1C are labelled by the same reference symbols, and the explanation thereof are not repeated here.

FIG 7A is a schematic diagram of the projection exposure apparatus of the modified example. In FIG. 7A, the light sources 3A, 3B, which emit the illumination light beams IL2A, 1L2B of wavelength $\lambda 2$, are installed at the positive and negative X direction sides of the reticle 4. The illumination light IL2A from the light source 3A passes through a condenser lens 9A and is reflected by a mirror 33A, which is inclined with respect to the incidence direction of the illumination light IL2A to guide the light IL2A toward the projection optical system 6. In the same manner, the illumination light IL2B from another light source 3B passes through a condenser lens 9B and is reflected by a mirror 33B, which is inclined with respect to the incidence direction of the illumination light IL2B to guide the light IL2B toward the projection optical system 6. The other conditions remain the same as the first example above.

FIG. 7B shows the illumination region on the reticle 4. In FIG. 7B, the illumination light IL1 from the light source 1 is transmitted through the rectangular illumination region 18, which circumscribes the circular boundary of the round-shape effective illumination region 14. On the other hand, each of the illumination light beams IL2A, IL2B from the light source 3A, 3B do not pass through the reticle 4. However, regions on the reticle 4 that are defined by tracing back the optical paths of the light beams IL2A, IL2B assuming that there are no mirrors 33A, 33B have trapezoidal-shapes as shown in the dotted lines in FIG. 7A. Therefore, in the same manner as the first embodiment, the thermal energy distribution generated by emission of the light beams toward the lenses in the projection optical system 6 has high rotational symmetry. This can reduce fluctuations in aberrations in the projection optical system 6.

This modified example is effective when the mirrors 16A, 16B cannot be arranged at the upper side of the reticle 4 as in the first example due to space or layout considerations. However, in this modified example, a portion of the illumination light IL1 may be scattered by the mirrors 33A, 33B, which makes it difficult to tell the border between the illumination region 18 on the reticle 4 formed by the illumination light IL1 and the illumination regions 17A, 19A.

**Second example**

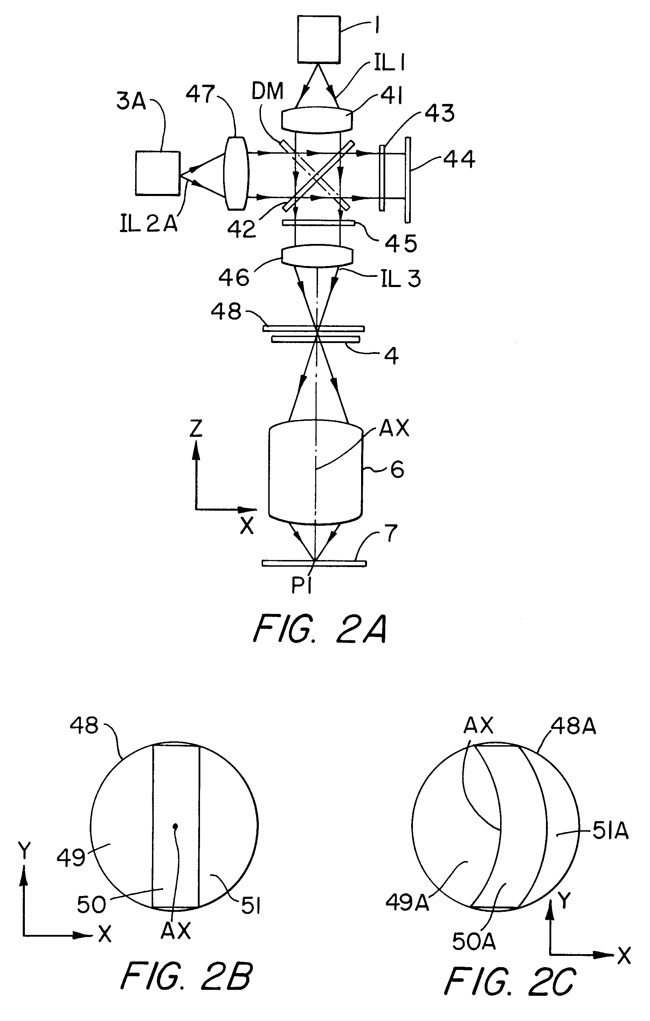

Next, the second example of the first preferred embodiment of the present invention is described with reference to FIGs. 2A to 2C. In this example, two light sources, a photosynthesizing system, and a field stop having wavelength selectivity, etc., are used to create symmetrical thermal energy distribution on the lenses in the projection optical system. The basic configuration remains the same as the first embodiment. In FIGs. 2A to 2C, the components similar to those of FIGs. 1A to 1C are labeled by the same reference numerals or labels and the explanation thereof are not repeated here. Also, some components such as a wafer stage are not illustrated in the figures.

FIG. 2A is a schematic view of the projection exposure apparatus of the present example. In FIG. 2A, the illumination light IL1 of wavelength $\lambda 1$, which can sensitize (expose) the photoresist on the wafer 7, becomes a parallel beam through a relay lens 41, and enters a condenser lens 46 through the polarization beam splitter 42. Illumination light beams IL1 and IL2A are linearly p-polarized before entering the polarization beam splitter 42. Another illumination light IL2A of wavelength $\lambda 2$, which does not sensitize (expose) the photoresist on the wafer 7, is emitted from a light source 3A, and becomes a parallel beam through a relay lens 47. The illumination light IL2A is directed toward the a polarization beam splitter 42 in the direction perpendicular to the propagating direction of the illumination light IL1. The illumination light IL2A that passes through the polarization beam splitter 42 enters a 1/4 wavelength plate 43 and is reflected by a mirror 44. Then, it goes back along its optical path through the 1/4 wavelength plate 43 and enters the polarization beam splitter 42 as an s-polarized beam. The s-polarized illumination light IL2A is reflected by the polarization beam splitter 42, and is combined with the illumination light IL1 to yield a combined illumination light beam IL3. The illumination light beam IL3 is guided toward the reticle 4 via the condenser lens 46. Also, a 1/4 wavelength plate 45 is placed between the polarization beam splitter 42 and the condenser lens 46 so that the illumination light IL3 acquires circular polarization before impinging on the reticle 4. This provides excellent exposure results even if the direction of the reticle pattern on the reticle 4 changes.

A field stop 48 having wavelength selectivity is arranged just above the reticle 4. The field stop 48 defines illumination regions on the reticle 4 for the illumination light beams IL1 and IL2A which constitute the illumination light IL3. The field stop 48 is composed of two types of optical filters which have different wavelength selectivity, for example.

FIG. 2B is the plan view of the field stop 48. An optical filter 50, which is a rectangular shape and extending in the non-scanning direction (Y direction), is provided at the center of the field stop 48. The light beam of wavelength $\lambda 1$ (illumination light IL1 in this case) is selectively transmitted through the optical filter 50. The field stop 48 is arranged in the vicinity of the reticle 4 in this example, and accordingly, the shape of the optical filter 50 directly corresponds to the illumination region on the retide 4 for the illumination light IL1. Also, semi-circular-like optical filters 49, 51, which selectively transmit the illumination light IL2A of wavelength $\lambda 2$, are installed on the left and right sides of the optical filter 50 on the field stop 48. The optical filters 50, 49, 51 together constitute the filed stop 48 and form a round-shape region around the optical axis AX. This round region is inside the effective illumination region on the reticle 4.

The illumination light beams IL1, Il2A that pass through the field stop 48 and the reticle 4 illuminate the wafer 7 through the projection optical system 6. The illumination light IL2A does not sensitize (expose) the photoresist on the wafer 7, and accordingly, only the image of the pattern on the reticle 4 that is inside the optical filter 50 is transferred onto the wafer 7.

In addition, the illumination light IL1 from the light source 1 and the illumination light IL2A from the light source 3A simultaneously enter the projection optical system 6. Therefore, the distribution of the thermal energy density absorbed on the glass material in the projection optical system 6 has good rotational symmetry around the optical axis AX. This reduces fluctuations in aberrations. In the conventional projection exposure apparatus, if the thermal distortion of the glass material has significant rotational asymmetry, the best image plane of a pattern in the meridional direction and the best image plane of the pattern in a direction perpendicular to the meridional direction may be separated in the optical axial direction at the center of the exposure field of the projection optical system. This astigmatism is referred to as "center-astigmatism." This example of the present invention is suitable for reducing such rotational asymmetry in fluctuations in aberrations, such as this "center-astigmatism". Also, the technique used in this example is particularly effective when an arc-shape exposure region is used as described below.

FIG. 2C a plan view of another field stop 48A suitable for an arc-shape exposure region. In FIG. 2C, at the center of the field stop 48A, an arc-shape optical filter 50A, which selectively transmits the illumination light IL1 from the light source 1 is installed. On the left and right sides of the optical filter 50A above the field stop 48A, a filter 49A and a crescent shaped optical filter 51A, which selectively transmit the illumination light IL2A of wavelength $\lambda 2$, are installed. These optical filters 49A, 51A, and 50A are shaped to define a round-shape region around the optical axis AX as a whole. In this example, the pattern inside the annular filter 50A is projected on the wafer 7 via the projection optical system 6. Also, emission energy, whose distribution is symmetrical around the optical axis AX, is supplied to the projection optical system 6, thereby reducing the aberration fluctuations.

If the first example of the first preferred embodiment above is used here in the case of the arc-shape illumination region, complex shapes would be required for field stops in the light sources 1, 3A, 3B to provide symmetrical emission energy to the glass material in the projection optical system 6. This will increase the manufacturing cost. According to this second example, the optical filter 50A can easily be shaped to correspond to the arc-shape illumination region on the reticle 4. Also, the optical filters 49A, 51A for the illumination light IL2A can also be shaped according to the shape of the filter 50A.

Note that a filter which has as small transmissivity as possible for the illumination light from the light source 3A is preferable for the optical filter 50 because it significantly reduces aberration fluctuation due to the rotationally asymmetric thermal energy distribution in the projection optical system 6. Also, in order to efficiently reduce the aberration fluctuation of the projection optical system 6, it is desirable that the combined area of the optical filters 49, 51, in the circle inscribing the optical filter 50, is at least half of or larger than the area of the circle exduding the area that the optical filter 50 occupies.

In the embodiment shown in FIG. 2A, the field stop 48 is arranged close to the pattern surface of the reticle 4. Alternatively, the field stop 48 may be placed at a position that is conjugate with the pattern surface of the reticle 4.

In FIG. 2A, a dichroic mirror DM may be used as a photo synthesizing system in place of the polarization beam splitter 42, as shown in the two dotted chain lines. The dichroic mirror DM has wavelength selectivity such that it transmits the illumination light IL1 and reflects the illumination light IL2A. Thus, the 1/4 wavelength plate 45 is not necessary, and accordingly, the illumination light beams IL1, IL2A can be efficiently combined.

According to the second example of the present embodiment, a first and second illumination light beams IL1, IL2A are first combined through the synthesizing system (42, 44, 46). Then, the combined light is guided toward the reticle 4 by the field stop 48. In this case, the field stop 48 allows only the first illumination light IL1 to pass the first transmissive portion 50. Therefore, the pattern image on the mask (reticle) 4 corresponding to only the first region 50 is transferred onto the photosensitive substrate 7.

On the other hand, the first illumination light IL1 and the second illumination light IL2A enter the projection optical system 6. The first illumination light IL1 passes through the first region 50 on the mask 4 and the second illumination light IL2A passes through the second region (49, 51) on the mask 4. The overall illumination regions (50, 49, 51) becomes a substantially rotationally symmetric region 48. This makes the thermal energy generated by emitting beams onto lenses in the projection optical system 6 to be distributed more symmetrically, in the same manner as the first example of the first embodiment of the present invention. This way, the aberration fluctuation in the projection optical system 6 can be reduced. In addition, in this second example, the optical system for defining the field of view for the first illumination light IL1 and the optical system for defining the field of view for the second illumination light IL2A on the mask 4, which are necessary in the first example, can be eliminated in the present invention.

Also, it is preferable that a predetermined symmetrical round exposure region 20 on the photosensitive substrate 7, which is conjugate with the predetermined round illumination region 48, corresponds to the field of view of the projection optical system 6 at the substrate side. This way, lenses in the projection optical system 6 are symmetrically illuminated with its maximum diameter. This help distributing the therial energy generated in the lenses by illumination of light even more symmetrically.

**Third example**

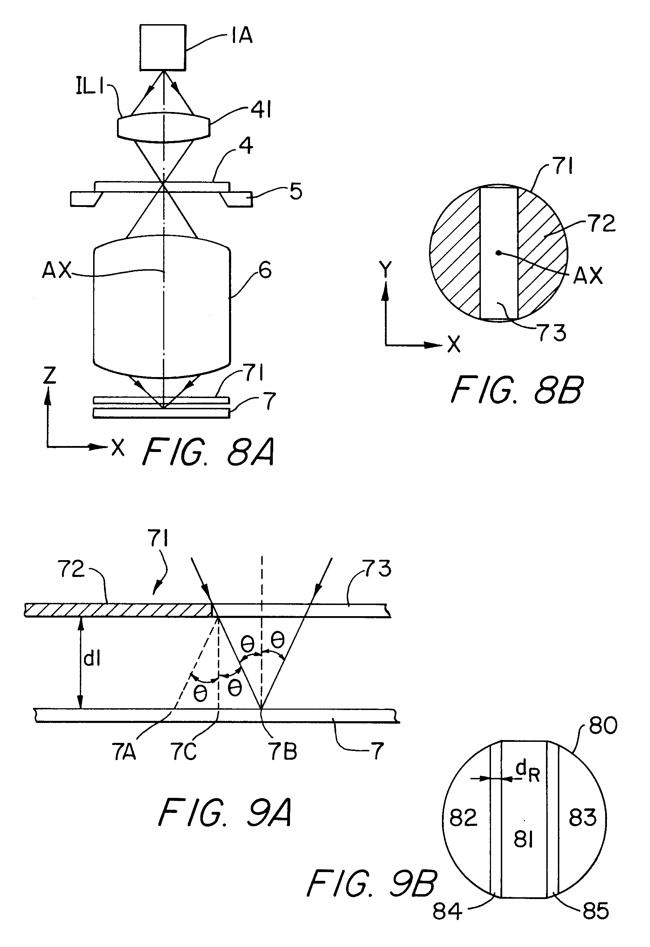

Next, a third example of the projection exposure apparatus according to the first embodiment of the present invention is described with reference to FIGs. 8A and 8B. In this example, a single light source is used and a light-shielding plate is installed between the projection optical system and the wafer. In FIGs. 8A and 8B, the same components as those shown in FIGs. 1A to 1C and 2A to 2C are labeled by similar reference numerals or symbols and the explanations thereof are not repeated here.

FIG. 8A is a schematic view of a projection exposure apparatus according to the third example of the first preferred embodiment of the present invention. In FiG. 8A, exposing illumination light IL1, which is capable of exposing the photoresist, is emitted from light source 1A and illuminates the reticle 4 through condenser lens 41. In this example, the illumination region of the illumination light IL1 on the reticle 4 is not rectangular shape, as in the case of the illumination region 18 in FIG. 1B, but a circular (round) effective illumination region which is conjugate with the effective exposure field of the projection optical system 6. The illumination light IL1 having such a circular cross-section enters a light-shielding plate 71 arranged above the wafer 7.

FIG. 8B is a plan view of the light-shielding plate 71. In FIG. 8B, the center of the round-shape light-shielding plate 71 coincides with the optical axis AX of the projection optical system 6. A transmissive (transparent) region 73, which is rectangularly shaped and elongated along the Y direction, is formed around the center of the light-shielding plate 71.

In addition, light-shielding portion 72 is formed to surround the transmissive region 73. Of the illumination light IL1 entering the light-shielding plate 71, only the light that passes through the transmissive region 73 illuminates the wafer 7. This way, only the image of the pattern on the reticle 4 that corresponds to the transmissive region 73 on the light-shielding plate 71 is transferred on the wafer 7.

According to the present example, only the image of the pattern in the desired rotationally asymmetrical region (rectangular region in this case) on the reticle 4 can be transferred. This can simplify the configuration of the illumination optical system defining the illumination region for the illumination light IL1. Also, single light source 1A is used in this embodiment. Therefore, the components, such as extra light source and condenser lens, etc., which are necessary in the example of FIGs. 1A to 1C, 2A to 2C, and 7A, 7B, can be eliminated. In addition, since only a light-shielding plate needs to be provided in this example, its construction and adjustment can be simplified.

In this example, since the illumination light IL1 from the light source 1A illuminates a rotationally symmetric region in the projection optical system 6, the absorbed energy density distribution in the glass material of the projection optical system 6 has high rotational symmetry around the optical axis AX. This helps drastically decreasing aberrations due to the thermal distortion of the glass material in the projection optical system 6.

In this example, a plate replacing mechanism for replacing the light-shielding plate 71 may be provided to select the light-shielding plate that has a desired transmissive region corresponding to a particular exposure region. Also, a field of view adjustment mechanism that is capable of changing the shape of the transmissive region 73 may be provided in place of the light-shielding plate 71.

In this embodiment of FIG. 8A, if a finite distance d1 exists between the wafer 7 and the light-shielding plate 71 for mechanical reasons, the illumination light may be undesirably scattered by the light-shielding plate 71 and thus the wafer 7 may be unevenly illuminated (and the boarder line of the illumination region on the wafer may be blurred). This problem can be solved by providing a light-shielding plate 80 (or member 80) in the vicinity of the reticle or at the conjugate position with respect to the reticle on the light source side. The member 80 has light-shielding belts 84, 85 of width $d_R = 2\beta \cdot d1 \cdot \tan \theta$ (where $\beta$ is a projection magnification, such as 1/4, 1/5 etc., and sine $\theta$ is the maximum numerical aperture (NA) of the exposure light as viewed from the wafer, as shown in FIG. 9A). The light-shielding belts 84, 85 should be positioned at the both sides of region 81 which is conjugate with the exposure region on the wafer 7, as shown in FIG. 9B. In this case, the illumination light IL1 in FIG. 8A passes through regions 81, 82, 83 but is blocked at the light-shielding belts 84, 85.

FIG. 9A is a cross-sectional view of light shielding plate 72 and wafer 7. A portion of the wafer 7 between points 7A and 7B corresponds to the light shielding belt 85 of width $d_R$. Therefore, no light illuminates that region on the wafer. If the border between the transmissive region 73 and the light-shielding belt 72 is arranged above the mid point 7C between the points 7A, 7B, and the light-shielding belt 84 is configured in the same way, the light-shielding plate 71 does not produce undesirable scattering described above. Since the width $d_R$ of the light-shielding belts 84, 85 is normally much smaller than the diameter of the circular member 80, the lenses in the projection optical system 6 of FIG. 8A are illuminated in a nearly rotationally symmetrical manner. This is sufficient to suppress aberration fluctuations.

In the third example of the first preferred embodiment according to the projection exposure apparatus of the present invention, single illumination light IL1 illuminates a mask 4. Therefore, a beam of a uniform wavelength illuminates all the lenses in the projection optical system 6. As a result, rotationally asymmetrical thermal distortion and aberrations in the projection optical system 6 can be reduced.

**Sample Calculations I**

Next, reduction of aberration fluctuations in the projection optical system in the above preferred examples are demonstrated by sample calculations. First, a temperature rise due to illumination energy is calculated. In the embodiment shown in FIG. 1A, the lens in the projection optical system 6 is approximated by a cylindrical shape. Also, it is assumed that the edge of the lens contacts a metal and heat flows only through the edge of the lens (no heat leakage from the surface of the lens to the air). Representing the distance in the lens in the radial direction by r, the yawing angle by $\varphi$, the resultant temperature distribution by T(r, $\varphi$), the heat absorption amount of the lens per unit volume by $\omega$(r, $\varphi$), the thermal conductivity of the lens by $\lambda$, and the outer radius of the lens by a, the heat conduction equation for T(r, $\varphi$) wider thermal equilibrium is as follows:

$$\frac{\partial^2 T}{\partial r^2} + \frac{1}{r}\frac{\partial T}{\partial r} + \frac{1}{r^2}\frac{\partial^2 T}{\partial \phi^2} + \frac{\omega(r,\phi)}{\lambda} = 0. \tag{1}$$

This heat conduction equation (1) has the following formal solution:

$$T(r,\phi) = \sum_{i=1}^{\infty}\sum_{n=0}^{\infty} C_{in} \cdot J_n(p_{in}\cdot r)\ \cos(n\phi)$$

$$+\sum_{i=1}^{\infty}\sum_{n=0}^{\infty} S_{in} \cdot J_n(p_{in}\cdot r)\ \sin(n\phi), \quad \text{------------}\ (2)$$

where, $J_n(p_{in} \cdot r)$ is the $n$th order Bessel function of the first kind ($n=0, 1, 2, ...$) and $p_{in}$ ($i=1, 2, ...$) is a sequence satisfying $J_n(p_{in} \cdot \alpha)=0$. The coefficient $C_{in}$ is determined by the following equation:

$$C_{in} = \frac{\displaystyle\int_0^a\int_0^{2\pi}(\frac{\omega(r,\phi)}{\lambda})\ J_n(p_{in}\cdot r)\cdot \cos(n\phi)r\,dr\,d\phi}{\frac{\pi}{2}\cdot p_{in}{}^2\cdot a^2[J_{n+1}(p_{in}\cdot a)]^2} \quad \text{-----------}\ (3)$$

for $n=1,2, ...$ , and for $n=0$,

$$C_{i0} = \frac{\displaystyle\int_0^a\int_0^{2\pi}(\frac{\omega(r,\phi)}{\lambda})\ J_0(p_{i0}\cdot r)r\,dr\,d\phi}{\pi\cdot p_{i0}{}^2\cdot a^2[J_1(p_{i0}\cdot a)]^2}. \quad \text{-----------}\ (4)$$

The coefficient $S_{in}$ is determined by the following equation:

$$S_{in} = \frac{\displaystyle\int_0^a\int_0^{2\pi}(\frac{\omega(r,\phi)}{\lambda})\ J_n(p_{in}\cdot r)\cdot \sin(n\phi)r\,dr\,d\phi}{\frac{\pi}{2}\cdot p_{in}{}^2\cdot a^2[J_{n+1}(p_{in}\cdot a)]^2} \quad \text{-----------}\ (5)$$

To investigate which order of aberration fluctuations is dominant, the temperature distribution $T(r, \varphi)$ is expanded by the Fourier power series using the least-squares method. Here, the units for the temperature distribution $T(r, \varphi)$ is "°C" and the unit of r the distance r is "mm".

$$T(r,\phi) = \sum_{i=0}^{\infty}\sum_{n=0}^{\infty} B_{in}\cdot r^{i+n}\cdot \cos(n\phi) \quad \text{--------}\ (6)$$

where i= 0, 2, 4, 6, ... .

When i=0 and n=0, the coefficient $B_{00}$ is the temperature at the optical axis AX, (i.e., r=0). The effect of the first embodiment above is demonstrated based on actual parameters obtained by the first and second calculation examples. In the first calculation example, a rectangular illumination region is used as an illumination region for the exposure light on the reticle. The second calculation example, an arc-shape illumination region is used. In these calculations, the lens in the projection optical system 6 is collectively represented by lens 61 (See FIGs. 3A, 4A, 5A, and 6A). The lens is cylindrically shaped with radius 40 mm and is made of quartz. For quartz, the thermal conductivity is 0.0138 W/(cm • °C). The heat absorption rate of the lens 61 with respect to the illumination light IL1 of wavelength $\lambda$1, which can sensitize (expose) the photoresist on the wafer 7, is assumed to be 2%/cm.

Fist, the first calculation example assumes the following conditions: the illumination light IL1 illuminates only the illumination region 18, a 70 mm × 16.8 mm rectangle, on the lens. Thus, a rectangular absorption energy density is used as heat absorption amount $\omega(r, \varphi)$ in the above equations (3), (4), and (5). The results are inserted into the equation (2) to determine the solution of the heat conduction equation (1).

FIGs. 3A shows the state in which the illumination light IL1 is emitted onto the rectangular illumination region of the surface of the lens 61. In FIG. 3A, points L1', L2', N1', N2' correspond to points L1, L2, N1, N2 in the illumination region 18 in FIG. 1B. The rectangular illumination region 62 enclosed by the points L'1, L'2, N'1, N'2 has width DX=16.8 mm in the scanning direction and width DY=70 mm in the non-scanning direction. It is assumed that the illumination light IL1 uniformly illuminate the region 62 with the total illumination amount of 1W per unit time.

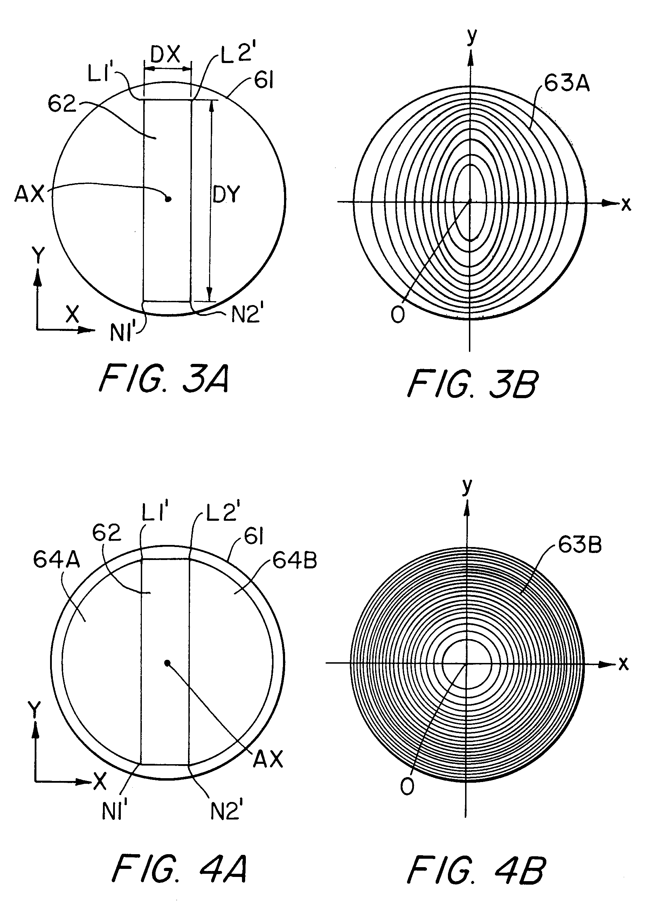

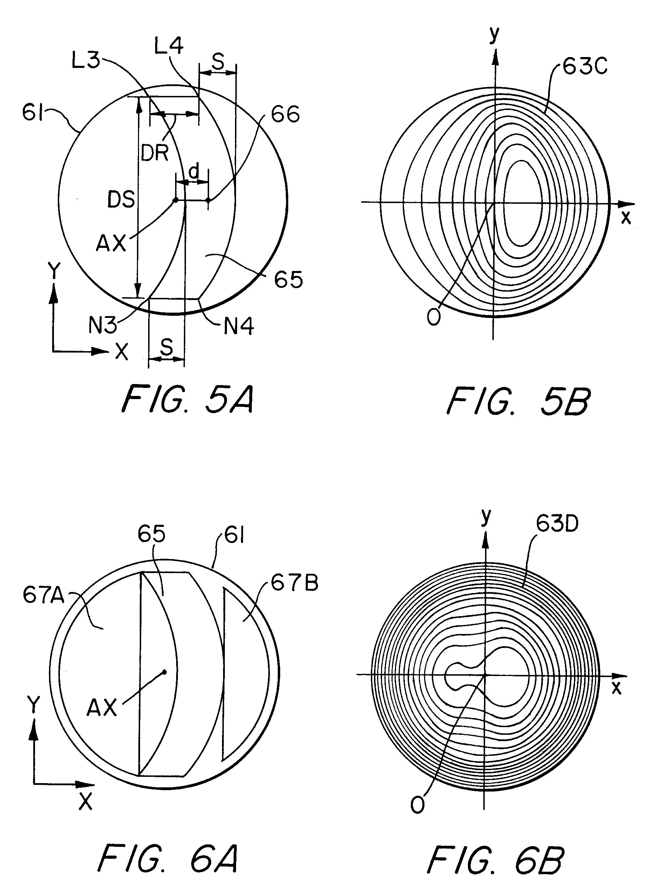

FIG. 3B shows the resulting data from the above calculations. The horizontal axis shows distance x from the optical axis AX in the scanning direction and the vertical axis shows distance y from the optical axis AX in the non-scanning direction. In FIG. 3B, the temperature distribution on the lens 61 is represented by isotherms 63A of pith 0.02°C. The temperature at the interior of the lens is higher than the periphery. Similarly, in FIGs 4B, 5B 6B, the horizontal axis represents distance x from the optical axis AX in the scanning direction and the vertical axis represents the distance y from the optical axis AX in the non-scanning direction, and isotherms 63B to 63D therein have a pitch of 0.02°C with temperature decreasing in the radial direction.

As shown in FIG. 3B, the isotherms 63A are oval-shaped around the optical axis AX and longer in the non-scanning direction when the illumination light IL1 is emitted onto the rectangular illumination region 62 on the lens 61 only. Near the periphery of the lens that is away from the optical axis AX on the lens 61, the isotherms are nearly rotationally symmetric but there is strong rotational asymmetry near the optical axis AX (at x = 0, y = 0).

Table 1 shows the series $B_{in}$, which result from Fourier power series expansion. The columns represent n (= 0, 1, 2, ...) and the rows represent i (= 0, 2, 4, ...), The values of coefficients $B_{in}$ for each of the n, i values are shown in the case of the calculation of FIG. 3A. The values in Table 1 will be compared with other calculations described below.

Table 1

|  | n=0 | n=1 | n=2 | n=3 | n=4 |
|---|---|---|---|---|---|
| i=0 | $2.2045 \times 10^{-1}$ | 0.0000 | $-2.4550 \times 10^{-4}$ | 0.0000 | $1.4452 \times 10^{-7}$ |
| i=2 | $-3.4345 \times 10^{-4}$ | 0.0000 | $6.3423 \times 10^{-7}$ | 0.0000 | $-3.3489 \times 10^{-10}$ |
| i=4 | $3.9964 \times 10^{-7}$ | 0.0000 | $-8.4516 \times 10^{-10}$ | 0.0000 | $3.1901 \times 10^{-13}$ |
| i=6 | $-3.6972 \times 10^{-10}$ | 0.0000 | $6.5133 \times 10^{-13}$ | 0.0000 | $-1.4221 \times 10^{-16}$ |
| i=8 | $1.8007 \times 10^{-13}$ | 0.0000 | $-2.6076 \times 10^{-16}$ | 0.0000 | $2.1215 \times 10^{-20}$ |
| i=10 | $-3.4325 \times 10^{-17}$ | 0.0000 | $4.1520 \times 10^{-20}$ | 0.0000 | $1.7302 \times 10^{-24}$ |

Next, based on the first example shown in FIG. 1A, the results of the calculation is described for the case of using illumination light beams IL2A and IL2B from the light source 3A, 3B together with the illumination IL1 from the light source 1. As seen from FIG 4A, the illumination regions of the illumination light beams IL2A, IL2B have slightly different shapes from that in the first example. However, the effects remain almost the same.

FIG. 4A shows the status of the illuminated lens 61. In FIG. 4A, the illumination light beams IL2A, IL2B are assumed to illuminate almost semi-circular illumination regions 64A, 64B located at the left and right sides of the illumination region 62. These illumination regions 64A, 64B contact the illumination region 62 within the circle on which the illumination region 62 is inscribed. Also, it is assumed that the lens 61 absorb the illumination light IL2A, IL2B of wavelength λ2, which does not sensitize (expose) the photoresist on the wafer 7, with the same energy absorption rate as for the illumination light IL1.

FIG. 4B shows the results of this calculation. In FIG. 4B, as isotherms 63B around the optical axis AX on the lens 61 shows, the temperature distribution on the lens 61 has high rotational symmetry around the optical axis AX. Also based on the results of the calculation, series data $B_{ln}$ in the Fourier power series expansion (equation (6)) can be obtained and the results are listed in Table 2 below.

Table 2

|  | n=0 | n=1 | n=2 | n=3 | n=4 |
|---|---|---|---|---|---|
| i=0 | $4.8298 \times 10^{-1}$ | 0.0000 | $1.7294 \times 10^{-7}$ | 0.0000 | $1.4452 \times 10^{-9}$ |
| i=2 | $-3.0498 \times 10^{-4}$ | 0.0000 | $5.4971 \times 10^{-9}$ | 0.0000 | $-1.4191 \times 10^{-11}$ |
| i=4 | $-2.5533 \times 10^{-7}$ | 0.0000 | $-1.8367 \times 10^{-11}$ | 0.0000 | $3.8936 \times 10^{-14}$ |
| i=6 | $6.3606 \times 10^{-10}$ | 0.0000 | $2.5913 \times 10^{-14}$ | 0.0000 | $-4.7191 \times 10^{-17}$ |
| i=8 | $-6.1809 \times 10^{-13}$ | 0.0000 | $-1.5972 \times 10^{-17}$ | 0.0000 | $2.6709 \times 10^{-20}$ |
| i=10 | $2.0495 \times 10^{-17}$ | 0.0000 | $3.4875 \times 10^{-21}$ | 0.0000 | $-5.6051 \times 10^{-34}$ |

Comparing the temperature distributions of FIGs. 3B and 4B, the thermal distribution of FIG. 4B has higher rotational symmetry. Also, comparing Tables 1 and 2, when i = 0, n = 0, the coefficient $B_{00}$, which is the temperature at the optical axis AX (r = 0), in Table 2 is larger than that in Table 1, and the absolute values of the other coefficients $B_{in}$ in Table 2 are smaller than the corresponding vales in Table 1. Among those series $B_{in}$ values, when n = 0, the fact that the series values except i=0 is smaller in Table 2 implies that the spherical aberrations caused by the illumination light fluctuate less. The fact that the series $B_{in}$ values are smaller in Table 1 when n=2 and n = 4 except n =0 implies that the rotationally asymmetrical aberrations caused by the illumination light fluctuate less. Therefore, this calculation shows that using the first example of FIG. 1A, rotationally asymmetrical aberrations, such as "center-astigmatism," caused by the illumination light is reduced.

Next, a second calculation example is described. This second calculation example quantitatively shows the effect of the first example on the case where an arc shape illumination region is used. First, for comparison, the calculation is performed when the illumination light IL1 of FIG. 1A only forms the arc-like shape annular illumination region on the reticle.

FIG. 5A shows the state in which the illumination light IL1 on the lens 61 in the projection optical system 6. In FIG. 5A, the lens 61 is illuminated by arc shape (or curved) illumination region 65 that has the same area as the rectangular illumination region 62 used in the first calculation example (FIG. 3A) and circumscribes the same circle as the illumination region 62. The purpose for using such curved illumination region 65 is to avoid the flare that may appear in the center of the projection optical system 6. For example, the region 65 is shaped to exclude the center region within 8.4mm from the optical axis AX. The center 66 of the illumination region 65 is distanced from the optical axis AX by d. The emission energy of the illumination light IL1 at the lens 61 is 1W. The linear distance DR between the two points L3 and L4 (or N3 and N4), which located near the top (bottom) corners of the arc-shape illumination region 65 is 16.8mm. The linear distance DS between the two points L4 and N4 (or L3 and N3), which are located near the side corners of the annular illumination region 65 in the X direction is 70mm. The distance S between the N3-L3 line and the tangent of the left arc of the illumination region 65 in the X direction in FIG. 5A is set to 25.2 mm to avoid the circular region of 8.4mm from the optical axis AX.

FIG. 5B shows the results of the calculation of the temperature distribution on the lens 61 after the temperature rises when the illumination light IL1 illuminates only the arc shape illumination region 65 on the lens 61. In FIG. 5B, as shown by the isotherms 63C of 0.02°C pitch, the temperature are distributed like deformed oval shapes extending in the non-scanning direction and shifted to the right from the optical axis AX. The series values $B_{in}$ in the Fourier power series in this case are shown in Table 3 below.

Table 3

|  | n=0 | n=1 | n=2 | n=3 | n=4 |
|---|---|---|---|---|---|
| i=0 | $1.6014 \times 10^{-1}$ | $6.3301 \times 10^{-3}$ | $3.3891 \times 10^{-5}$ | $-3.3261 \times 10^{-6}$ | $-6.5666 \times 10^{87}$ |
| i=2 | $-2.4216 \times 10^{-5}$ | $-1.0578 \times 10^{-5}$ | $-3.7951 \times 10^{-7}$ | $5.5797 \times 10^{-9}$ | $3.0172 \times 10^{-10}$ |
| i=4 | $-2.8996 \times 10^{-7}$ | $4.9472 \times 10^{-9}$ | $7.4108 \times 10^{-10}$ | $-2.8098 \times 10^{-12}$ | $-4.5946 \times 10^{-13}$ |
| i=6 | $3.6629 \times 10^{-10}$ | $2.0428 \times 10^{-12}$ | $-6.3917 \times 10^{-13}$ | $3.1792 \times 10^{-17}$ | $3.3061 \times 10^{-16}$ |
| i=8 | $-2.0179 \times 10^{-13}$ | $-2.6958 \times 10^{-15}$ | $2.7273 \times 10^{-16}$ | $2.8736 \times 10^{-19}$ | $-1.1903 \times 10^{-19}$ |
| i=10 | $4.2277 \times 10^{-17}$ | $6.8976 \times 10^{-19}$ | $-4.7047 \times 10^{-20}$ | $-4.0149 \times 10^{-23}$ | $1.7651 \times 10^{-23}$ |

Next, the data obtained under the condition in which the illumination light beams IL2A, IL2B from the light sources 3A, 3B of FIG. 1A are emitted together with the illumination light IL1 from the light source 1.

FIG. 6A shows the such a condition on lens 61. In FIG. 6A, the illumination light beams IL2A, IL2B evenly illuminate the semi-circular-like illumination regions 67A, 67B on the left and right sides, which are inscribed in the illumination region 65. In this case, as stated above, it is difficult to make the light sources 3A, 3B to perfectly fit the illumination regions of the illumination light beams IL2A, IL2B with the arc shape illumination region (65). In this calculation example, as shown in FIG. 6A, the illumination light beams IL2A, IL2B illuminate the illumination region 67A and the semi-circular illumination region 67B, respectively. The illumination region 67B has a straight line connecting the two end points of the annular illumination region 65 in the -X direction side as its side. The side of the semi-circular illumination region 67B is tangent to the annular illumination region 65. The energy absorption rate at the lens 61 with respect to the illumination light IL2A, IL2B of wavelength $\lambda 2$, which does not sensitize (expose) photoresist through the illumination regions 67A, 67B is assumed the same as that for illumination light IL1 illuminating the arc shape illumination region 65.

FIG. 6B shows the results of the calculation in the above-mentioned conditions. The temperature distribution shown by isotherms 63D in FIG. 6B has better rotational symmetry than that in FIG. 5B. Also, based on the results of the above calculation, series values $B_{in}$ in the Fourier power series are shown in Table 4.

Table 4

|  | n=0 | n=1 | n=2 | n=3 | n=4 |
|---|---|---|---|---|---|
| i=0 | $3.2613 \times 10^{-1}$ | $1.9780 \times 10^{-3}$ | $1.8782 \times 10^{-4}$ | $-4.4163 \times 10^{-6}$ | $-1.4622 \times 10^{87}$ |
| i=2 | $-9.3395 \times 10^{-6}$ | $-9.7035 \times 10^{-5}$ | $-6.8352 \times 10^{-7}$ | $1.8846 \times 10^{-8}$ | $6.0409 \times 10^{-10}$ |
| i=4 | $-4.7485 \times 10^{-7}$ | $1.9335 \times 10^{-8}$ | $1.1776 \times 10^{-9}$ | $-3.2278 \times 10^{-11}$ | $-9.7362 \times 10^{-13}$ |
| i=6 | $5.3783 \times 10^{-10}$ | $-1.9862 \times 10^{-11}$ | $-1.0660 \times 10^{-12}$ | $2.8311 \times 10^{-14}$ | $7.7335 \times 10^{-16}$ |
| i=8 | $-3.1285 \times 10^{-13}$ | $1.0210 \times 10^{-14}$ | $4.8154 \times 10^{-16}$ | $-1.2630 \times 10^{-17}$ | $-3.0439 \times 10^{-10}$ |
| i=10 | $7.1741 \times 10^{-17}$ | $-2.0517 \times 10^{-18}$ | $-8.5698 \times 10^{-20}$ | $2.2606 \times 10^{-21}$ | $4.7624 \times 10^{-23}$ |

Comparing Tables 3 and 4, not only the value $B_{00}$ but also quite a few other $B_{in}$ values in Table 4 are larger than those in Table 3.

In other words, in the first example of FIG. 1A, if an arc shape illumination region is used together with the complementary illumination patterns 67A, 67B, the rotationally asymmetric temperature distribution cannot sufficiently be corrected. This means that rotationally asymmetric aberration fluctuations cannot be corrected to a sufficient degree. Therefore, when using an arc-like shape exposure region, it is preferable to use the second example of FIG. 2A above. In this second example of the first preferred embodiment, the rotational symmetry of the energy distribution and the aberration fluctuations on the lenses in the projection optical system 6 are improved by providing the complementary illumination regions that are more fit in the area in the circular field of view excluding the illumination region of the illumination light IL1.

The present invention is not limited to the application to the projection exposure apparatus of the scan-exposure type. It can be applied to the projection exposure apparatus of the one-time exposure type such as "stepper" if a pattern in a rotationally asymmetrical region on a reticle is to be transferred onto a wafer.

In the first example of the first embodiment of the projection exposure apparatus according to the present invention, the first and second illumination light beams are emitted together on the photosensitive substrate. However, the second illumination light does not sensitize (expose) the photosensitive substrate. As a result, the first illumination light projects only the image of the pattern in the rotationally asymmetrical shot region on the mask. This image is transferred onto the rotationally asymmetrical exposure illumination region on the photosensitive substrate. The projection optical system is illuminated with light having an almost rotationally symmetrical cross-section as a result of combining the asymmetrical first exposure illumination light with the complementary second illumination light. This increases the symmetry of the thermal energy distribution generated by transmitting light through the lens in the projection optical system. This reduces thermal distortion and rotationally asymmetrical distribution in the index of refraction. As a result, the aberration fluctuation in a projection optical system can be reduced.

In the second example of the first embodiment of the projection exposure apparatus according to the present invention, the first and second illumination light beams combined by a synthesizing system together pass through the respective regions of a field stop and reach the photosensitive substrate through the projection optical system. The second illumination light does not sensitize the photosensitive substrate. Therefore, the first illumination light transfers the image of the predetermined mask pattern onto the photosensitive substrate. In this case, the first illumination light passes through only the corresponding first transmissive region, which is conjugate with a rotationally asymmetrical exposure region, and it transfers only the image of the mask pattern onto that portion of the photosensitive substrate. On the other hand, the first illumination light which transmits the first region of the mask and the second illumination light which transmits the second region on the mask both enter the projection optical system. The entire region, which the first and second light beams illuminate, is designed to have high rotational symmetry. Therefore, this can reduce the aberration fluctuation in the projection optical system in the same manner as the first example above. Also, this second example can eliminate the optical systems for defining the illumination regions of the first and second illumination light beams.

Also, the first and second examples of the projection exposure apparatus may be equipped with a mark detection system that photoelectrically detects light from at least one of the two marks. One is a mask alignment mark on the mask, which is located in the region where the second illumination light illuminates. The other is a substrate alignment marks on the photosensitive substrate, which is located in the region where the second illumination light illuminates.

When a predetermined circular exposure area on the photosensitive substrate or a region of a photosensitive substrate that is conjugate with a predetermined rotationally symmetrical region coincides with the field of view of the projection optical system on the photosensitive substrate side, the lenses in the projection optical system is illuminated in a rotationally symmetrical manner with a maximum diameter. This improves the symmetry in the energy distribution on the lenses in the projection optical system.

In the third example of the projection exposure apparatus above, exposing illumination light, which can expose the photosensitive substrate, passes through a region on a light shielding plate that only corresponds to the rotationally asymmetrical region on the mask to be exposed. Therefore, only the image of a pattern in the asymmetrical region on the mask is transferred onto the photosensitive substrate. In addition, since the exposing illumination light illuminates the almost rotationally symmetrical region on the mask, the symmetry of the thermal energy distribution increases in the optical system. In the present example, since only one illumination light illuminates the mask, lenses in the projection optical system are illuminated with photo energy of a single wavelength light. Thus, the thermal energy absorption amount is evenly distributed in the lenses of the projection optical system, decreasing the thermal distortion of the lenses and aberration fluctuations of the projection optical system. This way, additional light sources and illumination optical systems, etc. may be eliminated.

## Second Preferred Embodiment

### First example

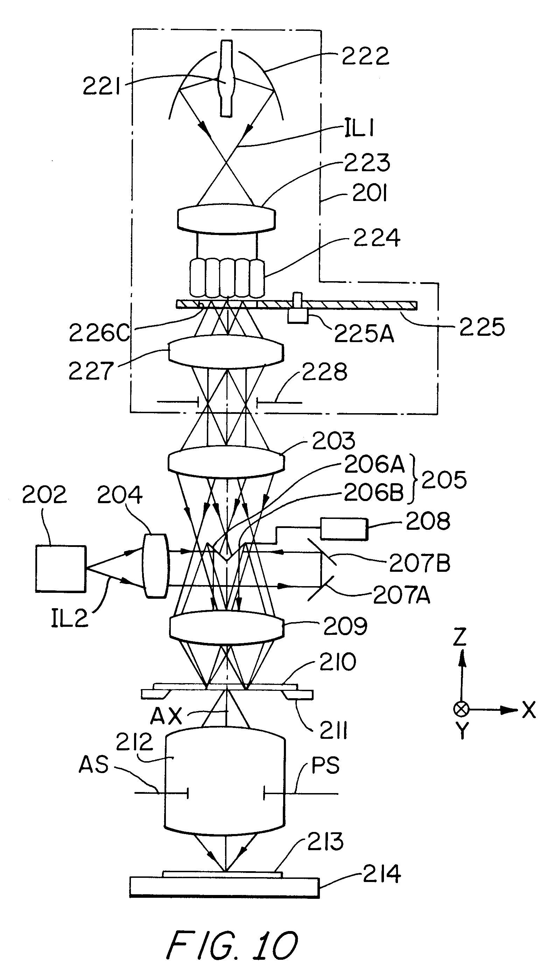

In the following, a first example of a second preferred embodiment of the projection exposure apparatus according to the present invention will be described with reference to FIGs. 10 through 12B. This example is one in which the present invention is applied to a "stepper" type projection exposure system that projects a reticle pattern through projection optics onto the shot areas of a wafer.

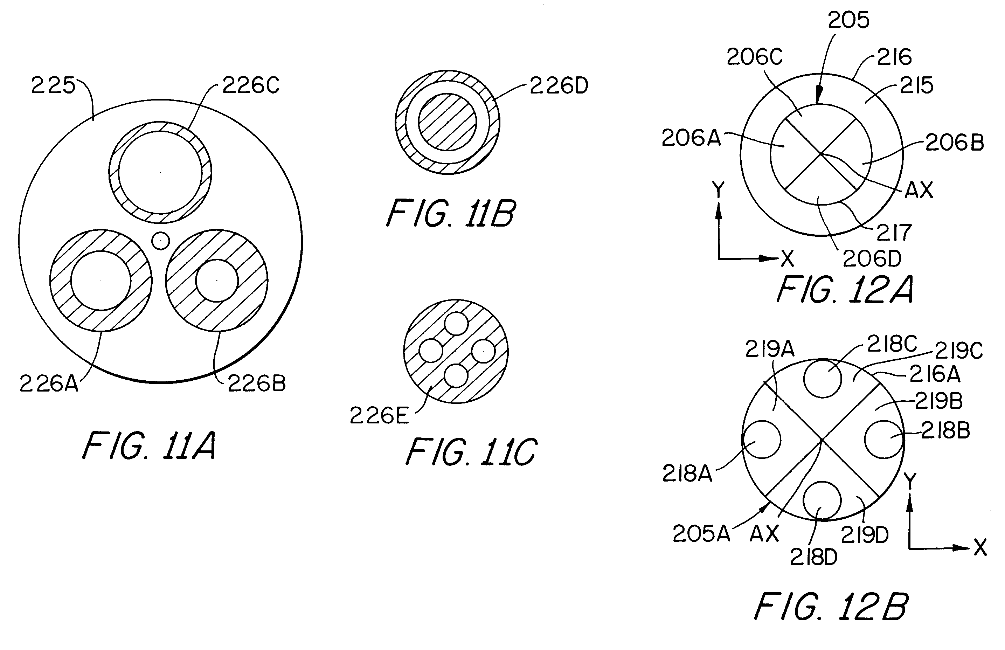

FIG. 10 is a simplified schematic diagram showing the configuration of the projection exposure apparatus in this example. Projection exposure systems, such as the one in the example of FIG. 10, are provided with three light source units (two of which, light source units 201 and 202, appear in FIG. 10). During exposure, first light source unit 201 emits illumination light IL1 of wavelength $\lambda 1$, which can expose the photoresist on wafer 213. Second light source unit 202 and third light source unit 203 (not illustrated) emit illumination light IL2 of wavelength $\lambda 2$, which can not expose the photoresist on wafer 213. In light source unit 201, the light emitted from light source 221, a mercury vapor lamp, for example, is converged at a second focal point by elliptical mirror 222. The light is then incident on an interference filter, etc. (not illustrated), as divergent light. The light extracted by the interference filter (e.g. i-line, $\lambda=365$ nm) is illumination light IL1. Next, illumination light IL1 is formed into a collimated beam by input lens 223 and is incident on fly-eye lens 224, which acts as an optical integrator. Each of the exit surfaces of the lens elements of fly-eye lens 224 serves a secondary light source, and these secondary light sources together form a planar light source. Placed on the exit surface of fly-eye lens 224 are a plurality of switch-selective aperture stops 226A - 226C (FIG. 11A) for adjusting the size of the planar light source. These aperture stops 226A - 226C are formed to turret-type turntable 225, which can be rotated by drive unit 225A to set the desired aperture stop at the exit surface of fly-eye lens 224.

FIG. 11A is a plan view showing the specific configuration of the aperture stops in turntable 225 of FIG. 10. In FIG. 11A, three aperture stops 226A - 226C are disposed around the periphery of turntable 225 at equal intervals (equal angle intervals). First aperture stop 226A has a circular aperture that is used for normal illumination. Second aperture stop 226B has smaller circular aperture used for illumination with a small coherence factor ($\sigma$ value). Aperture stop 226C has a larger circular aperture. In the present example, when annular illumination (annular illumination) or modified illumination (modified illumination) is performed, this third aperture stop 226C is positioned at the exit plane of fly-eye lens 224. That is, for normal annular illumination, annular aperture stop 226D shown in FIG. 11B is used, while for modified illumination, aperture stop 226E, which has four small apertures centered around the optical axis, as shown in FIG.

11C, is used. In this example, however, aperture stop 226D, etc. is used in conjunction with guiding mirror 205 (to be described later). In FIG. 10, the system is shown with third aperture stop 226C placed in the illumination light IL1 light path.

Referring to FIG. 10, illumination light IL1 passes through aperture stop 226C and is directed toward field stop (reticle blind) 228 through first relay lens 227. The field stop 228 determines the range of illumination. This illumination-range-determined illumination light IL1 is emitted from the light source unit 201, and passes the periphery of guiding mirror 205 through second relay lens 203. The guiding mirror 205 is constructed of four mirrors 206A - 206D (only 206A and 206B are shown in FIG. 10). The four mirrors are arranged in the faces of a four-sided pyramid centered on optical axis AX of the illumination optical system, with the concave end (the base of the pyramid) facing toward second relay lens 203. The reflective surfaces of the four mirrors of the guiding mirror 205 face outward, and are tilted at an angle of approximately 45° relative to optical axis AX of the illumination optical system. The top surface of guiding mirror 205 is positioned to be conjugate with a plane at which aperture stop 226C is placed. Illumination light IL1 that has passed the periphery of the guiding mirror 205 passes through condenser lens 209 to be incident upon the reticle 210.

FIG. 12A is a plan view of guiding mirror 205 of FIG. 10, as viewed from the reticle 210 end. As shown in FIG. 12A, mirrors 206A - 206D all have the same size and shape, and are arranged and mated to form a four-sided pyramid with its vertex located at the optical axis AX of the illumination optical system. Also, the combined outline 217 of the bottom surfaces of mirrors 206A - 206D forms a circle that has its center along the optical axis AX. These elements are configured such that illumination light IL1 passes through the annular-shaped area 215 formed between outline 217 and outline 216 which is the outline of the image of the aperture in the aperture stop 226C of FIG 10. In other words, guiding mirror 205 also functions as a annular-shaped aperture stop (annular aperture stop).

Referring to FIG. 10, the guiding mirror 205 can be taken out of the optical path of illumination light IL1, and can be replaced with a different mirror. This operation is performed by retract-and-replace unit 208.

Second light source unit 202 includes a light source for "non-exposure light" and a lens system that directs the light from that light source as a beam having a specific divergence angle. Illumination light IL2 (light that cannot expose the photoresist), emitted from the light source 202 placed above and to the left of reticle 210, is collimated by relay lens 204. A portion of this light is then incident upon mirror 206A of the guiding mirror 205 in a direction perpendicular to optical axis AX of the illumination optical system, and is reflected downward therefrom. Illumination light IL2 that passes under mirror 206A are reflected by mirrors 207A and 207B to be incident on mirror 206B of guiding mirror 205. The light reflected from mirror 206B enters condenser lens 209 along with the light beam reflected from mirror 206A. Although not shown in FIG. 10, a third light source unit is installed to be oriented perpendicular to the page of FIG. 10, together with an optical system similar to the one constructed of light source unit 202, relay lens 204, and mirrors 207A and 207B. The light emitted by this third light source unit (this light also cannot expose the photoresist, which is also represented by IL2) is reflected downward from mirrors 206C and 206D (FIG. 12A) in the guiding mirror 205. Therefore, in FIG. 12A, this illumination light IL2 is reflected into the area of the inner circle of annular-shaped area 215, outside of which illumination light IL1 passes through.

In FIG. 10, reticle 210 is illuminated through condenser lens 209 by both the illumination light IL1 that passes through the periphery of guiding mirror 205 and the illumination light IL2 that is reflected by guiding mirror 205. The light beams IL1 and IL2 pass through the pattern area on the reticle, and illuminate wafer 213 through projection optical system 212. The projection optical system 212 is constructed such that the pattern surface of reticle 210 is conjugate with the front surface of wafer 213 with respect to exposing illumination light IL1. Since the photoresist on wafer 213 is not sensitive to illumination light IL2, only the image of the pattern on reticle 210 illuminated by exposure illumination light IL1 exposes the photoresist on wafer 213. Here, the pupil surface PS of the projection optical system 212, i.e., the optical Fourier transformation surface for the pattern surface of reticle 210, is conjugate with a plane in which aperture stop 226C is placed and the top surface of the guiding mirror 205. An aperture stop AS is placed at pupil surface PS.

The wavelength $\lambda 1$ of illumination light IL1 and the wavelength $\lambda 2$ of illumination light IL2 are chosen depending on the type of photoresist used and the type of glass material used in the projection optical system 212, etc. Normally, the wavelength $\lambda 1$ is less than 530 nm and the wavelength $\lambda 2$ is 530 nm or larger. In the present example, the i-line of a mercury lamp is used for exposure illumination light IL1. Alternatively, the g-line ($\lambda = 436$ nm) emission line of a mercury lamp, ArF excimer laser light ($\lambda = 193.2$ nm), KrF excimer laser light ($\lambda = 248.5$ nm), or harmonics of copper vapor or YAG lasers may be used. For illumination light IL2, the wavelength must be incapable of exposing the photoresist, and preferably, the light absorption amount per unit area of the glass material and coatings used for the lens with respect to the illumination light IL2 is close to that for illumination light IL1. Accordingly, for illumination light IL2, if the coefficient of absorption is low, a high intensity light source needs to be used. On the other hand, if a lower intensity light source is used, its coefficient of absorption for the coating used on the projection optical system 212 lens needs to be large. One example of a possible light source for illumination light IL2 is the laser beam from an He-Ne laser ($\lambda = 633$ nm).

If the glass material used for the lenses of the projection optical system is quartz or other glass material that has good transmissivity for light ranging from the ultraviolet to near-infrared range, since these kinds of glass materials have fairly high absorption coefficients with respect to light having long wavelength of approximately 2 $\mu$m or greater, light

generated by an HF chemical laser ($\lambda$ = 2.4 - 3.4 $\mu$m), which uses chemical reaction of a hydrogen fluoride (HF) gas, may be used a illumination light IL2 s. Also, because non-quartz optical glasses contain impurities, some have light absorption rates near 1%/cm even at wavelengths greater than 530 nm. Even such illumination light with an absorption rate near 1%/cm, however, is effective. Examples of such illumination light include C-line ($\lambda$ = 656.3 nm) from a hydrogen ($H_2$) discharge tube and d-line ($\lambda$ = 587.6 nm) from a helium discharge tube.

In FIG. 10, optical axis AX of the illumination optical system coincides with the optical axis of the projection optical system. The Z axis is taken parallel to optical axis AX, the X axis is taken in the page and in a two dimensional plane perpendicular to the Z axis, and the Y axis is taken perpendicular to the page.

Reticle 210 is mounted on reticle stage 211, which is movable in the X, Y, and rotation directions by small amounts. The precise position of reticle stage 211 is measured by an external laser interferometer (not illustrated), and the position of reticle stage 211 is controlled based on these laser interferometer measurements. Wafer 213 is mounted via a wafer holder (not illustrated) on wafer stage 214, which positions the wafer in the X, Y, and Z directions. The precise position of wafer stage 214 is measured by an external interferometer, and the position of wafer stage 214 is controlled based on these laser interferometer measurements. The wafer stage 214 moves the wafer 213 so that the center of the shot areas of wafer 213 is aligned with the center of exposure of projection optical system 212, and then exposure is performed. These operation are repeated in a step-and-repeat scheme to transfer the image of the pattern on reticle 210 onto the shot areas of wafer 213.

The operation of the projection exposure apparatus of the present example will now be explained. In the present example, as shown in FIG. 10, annular illumination is performed using aperture stop 226C having a large aperture and guiding mirror 205. The annular illumination (or ring-band illumination) can achieve high resolution for a predetermined periodic pattern, for example. Also, as shown in FIG. 12A, exposure illumination light IL1 (to which the photoresist is sensitive) passes through annular-shaped area 215 in a plane that is approximately conjugate with pupil surface PS of projection optical system 212. On the other hand, illumination light IL2 (to which the photoresist is not sensitive) reflected from the reflective surfaces of guiding mirror 205, passes through the area corresponding to the inside of the annular-shaped area 215. If, with this illumination, illumination light IL1 and IL2 are pass through reticle 210 into projection optical system 212, the total illumination light made up of IL1 and IL2 will pass through a circular area in pupil surface PS of projection optical system 212 that has the optical axis AX as its center. Therefore, not only the peripheries, but the centers as well, of a lens near the pupil surface PS of projection optical system 212 absorb thermal energy and experience temperature rise. For the lenses located near pupil surface PS, this will result in a large ratio of the 2nd order component of distribution of the thermal distortion and index of refraction or the like with respect to the high order components of the distribution. Since spatial distribution of spherical aberration of projection optical system 212 is approximately proportional to distribution of thermal distortion and the index of refraction or the like of the lenses located near pupil surface PS, the 2nd order components of the spherical aberration distribution also becomes larger, thereby suppressing the high order spherical aberration fluctuations in projection optical system 212.

Although FIG, 10 shows the case of using the guiding mirror 205 for use in annular illumination, the present example is actually equipped with aperture stop 226E (FIG. 11C) and four-sided-pyramid-shaped guiding mirror 205A (FIG. 12B) for use in "modified" illumination. When performing the modified illumination, retract-and-replace unit 8 of FIG. 10 removes guiding mirror 205 from the illumination light IL1 light path and replace it with guiding mirror 205A.

FIG. 12B is a plan view of guiding mirror 205A as viewed from the side of the reticle 210 of FIG. 10. In FIG. 12B, the four mirrors 219A - 219D constitute guiding mirror 205A and all have the same size and the same fan-shape (sector like shape). These fan-shaped lenses are arranged with their sides mated to form a four-sided pyramid with its vertex coincident with the optical axis AX, and its convex side (the apex of the pyramid) faces reticle 210. The surfaces of mirrors 219A - 219D that face reticle 210 are reflective surfaces. If viewed from reticle 210 side, the outlines of mirrors 219A - 219D together form a single circumference 216A with its center coincident with the optical axis AX. This circumference 216A is approximately equal to outline 216 of the circular area of FIG. 12A, through which illumination light IL1 passes. Transparent sections 218A - 218D are formed at equal angular intervals inside the circumference 216 of the outlines of mirrors 219A - 219D. These sections appear as circles when viewed from the reticle 210 end. Transparent sections 218A - 218D are configured so that a portion of exposure illumination light IL1 of FIG. 10 pass through them. Thus constructed guiding mirror 205A is used in conjunction with modified illumination aperture stop 226E of FIG. 11C.

In other words, in the present example, when performing modified illumination, retract-and-replace unit 208 of FIG. 10 removes guiding mirror 205 and replace it with guiding mirror 205A such that the apex of the pyramid is aligned with optical axis AX and points toward the reticle 210. Illumination light IL1 passes through the four transparent sections 218A - 218D to illuminate reticle 210 of FIG. 10. On the other hand, "non-sensitive" illumination light IL2 (light to which the photoresist is not sensitive) is reflected from areas of guiding mirror 205A excluding transparent sections 218A - 218D inside circumference 216A of FIG. 12B, and is directed toward the reticle 210. Because the upper surface of guiding mirror 5A is conjugate with pupil surface PS of projection optical system 212, a circular area on pupil surface PS of projection optical system 212 around the optical axis AX is illuminated by illumination light beams IL1 and IL2. Therefore, in addition to achieving high resolution through the use of modified illumination, the high order spherical aberrations can be suppressed. Moreover, non-exposure illumination light 1L2 does not affect the imaging characteristics. When using normal illumination methods, retract-and-replace unit 8 retracts guiding mirror 205 or 205A from the illumination light IL1 path, and replace it with aperture stop 226A or 226B of FIG. 11A.

The system may also be configured such that illumination light IL1 is reflected by the reflective surfaces of guiding mirror 205 of FIG. 12A, or guiding mirror 205A of FIG. 12B, and a portion of illumination light IL2 is blocked. In such a configuration, for example, in FIG. 10, in addition to interchanging the placements of light source units 201 and 202 and their associated optical systems, gliding mirror 205 of FIG. 12A should be replaced with a guiding mirror that has a circular transparent portion in its center to pass illumination light IL2 and a ring-shaped reflective surface at the periphery of that transparent portion to reflect illumination light IL1 incident from a direction perpendicular to illumination light IL2.

## Modified first example

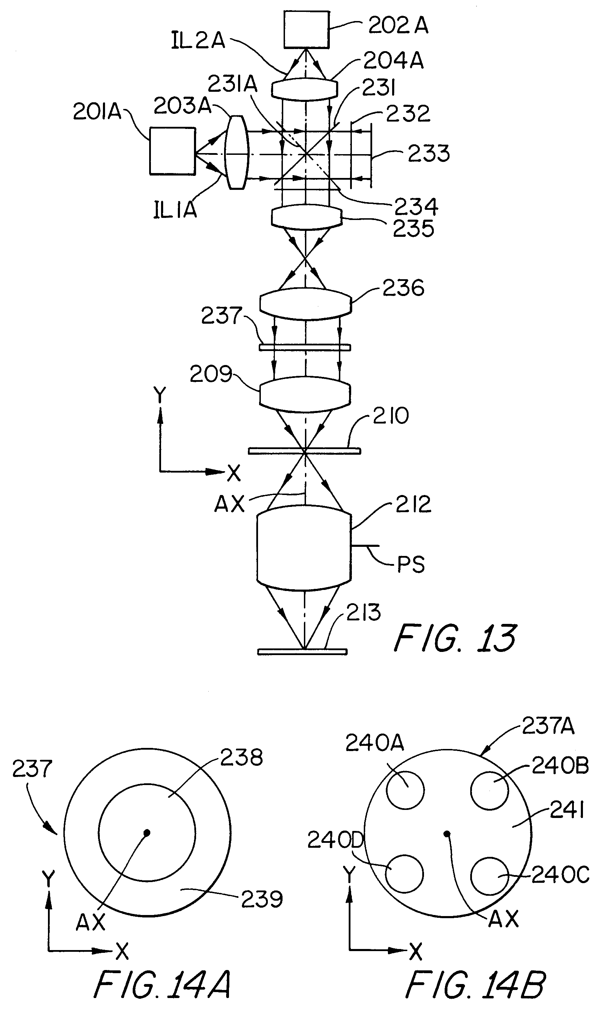

Next, a modified version of the first example above will be described with reference to FIG. 13. In this modified configuration, exposure illumination light and illumination light to which the photoresist is not sensitive are first combined to form a composite light. This composite light is then separated into two illumination light components by a wavelength-selective aperture stop provided in front of reticle 210 before illuminating reticle 210. In FIG. 13, like components as in FIG. 10 are labeled by the same reference numerals, and the detailed explanations thereof are not repeated here.

FIG. 13 is a schematic view of the projection exposure apparatus of this modified version example. In FIG. 13, light source unit 201A emits illumination light IL1A (to which the photoresist is sensitive) in the same manner as light source unit 201 of FIG. 10, and light source unit 202A emits illumination light IL2A (to which the photoresist is not sensitive) in the same manner as light source unit 201 of FIG. 10. These light sources are placed with their respective positions interchanged as compared with the configuration in FIG. 10. Polarization beam splitter 231 is placed at the intersection or illumination light IL1A and illumination light IL2A. For this modified first example, it is assumed that each of illumination light beams IL1A and IL2A be a linear P-polarized light beam. The P-polarized illumination tight IL2A having wavelength $\lambda 2$ emitted through the field stop in light source unit 202A is collimated by relay lens 204A. It then passes through polarization beam splitter 231, and is converted to circular-polarized light by quarter-wave plate 234. On the other hand, P-polarized illumination light IL1A, emitted through the field stop in light source unit 201A, is collimated by relay lens 203A. It then passes through polarization beam splitter 231 in a direction perpendicular to the light path of illumination light IL2A and passes through quarter-wave plate 232. The illumination light IL1A that has passed through the quarter-wave plate 232 is reflected by mirror 233, and again is incident upon quarter-wave plate 232 to be converted to S-polarized light. Illumination light IL1A that has been converted to S-polarized light is reflected by polarization beam splitter 231 and is incident upon quarter-wave plate 234 to become circular-polarized light. Illumination light IL1A and IL2A, having been converted to circular-polarized light by quarter-wave plate 234, pass through relay lenses 235 and 236 and are incident upon wavelength-selective aperture stop 237.

FIG. 14A is a plan view of the aperture stop 237. The aperture stop 237 includes two optical filters: annular optical filter 239, which is transparent with respect to illumination light IL1A of wavelength $\lambda 1$ and blocks illumination light IL2A of wavelength $\lambda 2$; and circular optical filter 238, which is transparent with respect to illumination light IL2A of wavelength $\lambda 2$, and blocks illumination light IL1A of wavelength $\lambda 1$. Aperture stop 237 is placed in a plane that is conjugate with the pupil surface PS of projection optical system 212 such that its center is aligned with the optical axis AX. Illumination light IL1A from light source unit 201A illuminates an area that includes annular optical filter 239, and illumination light IL2A from light source unit 202A illuminates an area that includes circular optical filter 238.

The two illumination light beams IL1A and IL2A that are combined by polarization beam splitter 231 passes through aperture stop 237 and are directed toward reticle 210 through condenser lens 209. The image of the pattern on reticle 210 is projected onto wafer 213 through projection optical system 212. At the pupil surface PS of projection optical system 212, illumination light IL1A and IL2A together pass through a nearly circular area, the same area as in the first example above. The optical paths of the IL1A and IL2A after this step are the same as that in the first example and the explanations thereof are not repeated here.

According to this modified first example, in addition to achieving the same effect of reducing high order spherical aberrations as in the first example, the complex structure associated with the use of guiding mirror 5 in the first example is not necessary. This is because in the modified first example, the areas through which illumination light IL1A and IL2A pass are defined by wavelength-selective aperture stop 237. In addition, the fact that this modified example uses a single light source unit 202A for light of wavelength $\lambda 2$ provides a more compact total system configuration. Also, since the two linearly polarized light beams combined by polarization beam splitter 231 are converted to circular polarized light by quarter-wave plate 234, in image formation on wafer 213, it will still be possible to transfer a good image of the pattern, even if the orientation of the pattern on the reticle 210 is changed. Also, dichroic mirror 231A (indicated by the double dotted line in FIG. 13) may be used in place of polarization beam splitter 231. Dichroic mirror 231A has wavelength selectivity, passing illumination light IL2A, but reflecting illumination light IL1A, a capability that enables it to combine illumination light IL1A and IL2A without wasting light. This simplifies the configuration by eliminating the need for quarter-wave plates 232, 234 and mirror 233.

The present modified example also provides for modified illumination aperture stop 237A to be substituted for aperture stop 237 of FIG. 13 via an apparatus (not illustrated) similar to retract-and-replace unit 208 of FIG. 10.

FIG. 14B is a plan view of another wavelength-selective aperture stop 237A, which can be used in place of aperture stop 237 of FIG. 13 in the case of modified illumination. In FIG. 14B, aperture stop 237A includes four small circular optical filters 240A - 240D and circular optical filter 241. Each of the circular optical filters 240A - 240D is transparent with respect to illumination light IL1A of wavelength $\lambda$1, but blocks illumination light IL2A of wavelength $\lambda$2. The circular optical filter 241 occupies an area of aperture stop 237 excluding optical filters 240A - 240D, and is transparent with respect to illumination light of wavelength $\lambda$2 IL2A, but blocks illumination light IL1A of wavelength $\lambda$1. Optical filter 241 has a circumference that is approximately equal to that of optical filter 239 of FIG. 14A, and includes, near its outer circumference, four small circular openings spaced at equal intervals (equal angular interval) around the circumference. Each of the four optical filters 240A - 240D is placed in each of these four openings. Exposure illumination light IL1A passes through the four optical filter, 240A - 240D, whereas illumination light IL2A, to which the photoresist is not sensitive, passes through optical filter 241 but not through optical filters 240A - 240D. This makes it possible to perform modified illumination while suppressing high order spherical aberration variations (distribution).

For more effective reduction of high order spherical aberration variations, the filter used for optical filters 238 and 240A - 240D in FIGs. 14A and 14B (the filters that pass illumination light IL1A from light source unit 201A) should have the lowest possible transmissivity for illumination light IL2A from light source unit 2A.

## Second example

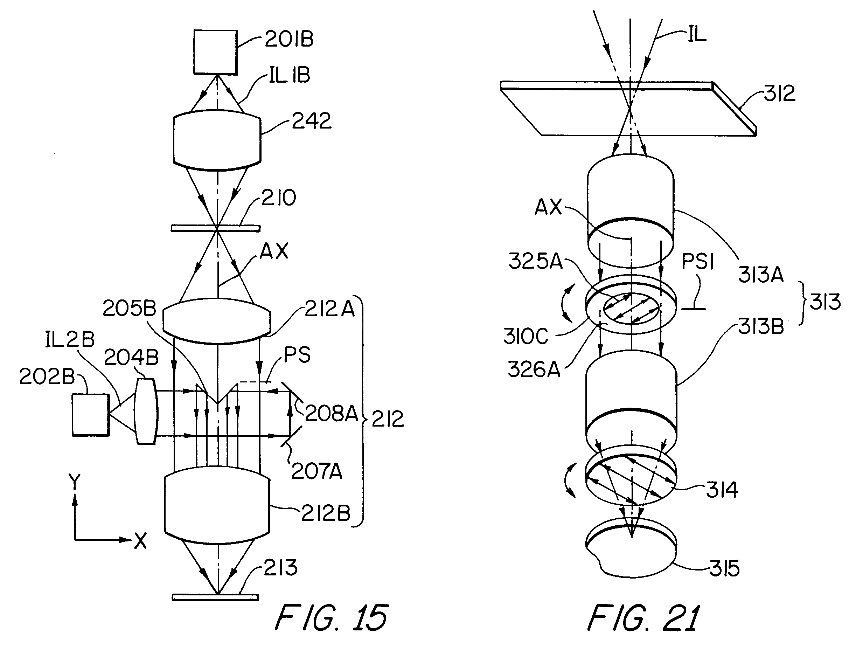

Next, a second example of the second preferred embodiment of the projection exposure apparatus according to the present invention will be described with reference to FIG. 15. This is an example of applications of the present invention to the case in which a ring-shape pupil filter is used. In FIG. 15, components, for which there are corresponding items in FIG. 10, are labeled by the same reference numerals and the detailed explanations thereof are not repeated here.

FIG. 15 is a schematic view of the projection exposure apparatus according to the present example. For simplicity, projection optical system 212 is separated into upper lens system 212A and lower lens system 212B. In this example, a four-sided-pyramid-shaped guiding mirror 205B (which is the same as guiding mirror 205B of FIG. 10) is placed near the pupil surface PS between upper lens system 212A and lower lens system 212B. Illumination light IL1B of wavelength $\lambda$1 (to which the photoresist is sensitive) is emitted through the field stop in light source unit 201B (which is the same as light source unit 201 of FIG. 10), and passes through condenser lens 242 to illuminate reticle 210. Like aperture stop 226C of FIG. 11A, the aperture stop in light source unit 201B is a large circle. The illumination light IL1B that has passed through reticle 210 undergoes optical Fourier transformation in upper lens system 212A, and passes by the periphery of guiding mirror 205B. Guiding mirror 205B thus shades a circular area centered on optical axis AX from illumination light IL1B. In other words, guiding mirror 205B also serves as a ring-shape pupil filter.

On the other hand, illumination light IL2B of wavelength $\lambda$2 (to which the photoresist is not sensitive) is emitted from light source unit 202B (which is the same as light source unit 202 of FIG. 10). After this light is collimated by relay lens 204B, a portion thereof is reflected toward wafer 213 by the first reflective surface of guiding mirror 205B. As in the first example shown in FIG. 10, mirrors 207A and 208A are placed such that the illumination light IL2B that passes under guiding mirror 205B is reflected to be incident upon the second reflective surface of guiding mirror 205B.

In addition, a light source that supplies light of wavelength $\lambda$2 to the third and fourth reflective surfaces of guiding mirror 205B is provided in a direction perpendicular to the page in FIG. 15. Illumination light IL2B reflected by guiding mirror 205B illuminates wafer 213 through lower lens system 212B. In this example, exposure illumination light IL1B is shaded in an area near optical axis AX by guiding mirror 205B placed at pupil surface PS of optical system 212. Because of this, high resolution is obtained for the predetermined pattern (the same resolution as would be realized with an annular center shading filter installed). Also, the glass in lower lens system 212B is illuminated with uniform intensity distribution by illumination light composed of two light beams IL1B and IL2B. Therefore, high order fluctuations in thermal distortion and index of refraction are suppressed, thereby reducing the high order spherical aberration fluctuations in the projection optical system 212.

As in the first example above, the system may also be configured such that illumination light IL1B (to which the photoresist is sensitive) is reflected by the reflective surfaces of guiding mirror 205B, while illumination light IL2B (to which the photoresist is not sensitive) is transmitted through a portion of the guiding mirror 205B that excludes the reflective surfaces. Referring to FIG. 15, the system could be reconfigured in this manner by replacing light source units 201B and 2B, reticle 210, and upper lens system 212A and the associated optics and by using a guiding mirror that has a circular aperture transparent to illumination light IL2B around its center, with an annular-shaped reflective surface around the aperture for reflecting illumination light IL1B received from a direction perpendicular to illumination light IL2B.

## Modified second example

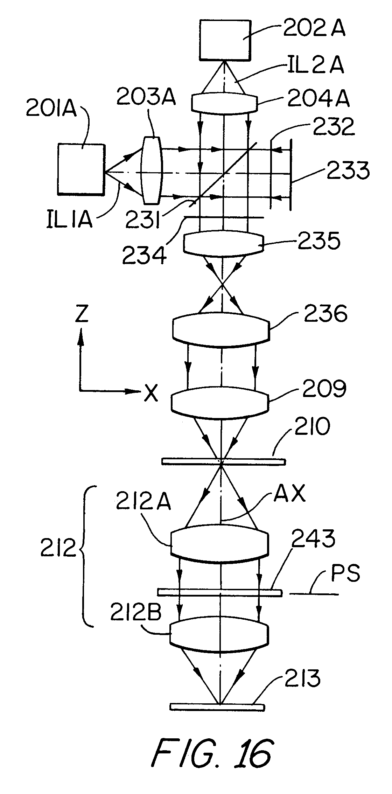

Next, a modified second example of the second embodiment of the present invention will be described with reference to FIG. 16. In this modified second example of the projection exposure apparatus according to the present invention, the configuration up to the projection optical system is nearly the same as the modified first example of FIG. 13 except for aperture stop 237. Components in FIG. 16, for which there are corresponding components in FIGs. 13 and 15, are labeled by the same reference numerals, and the detailed explanations thereof are not repeated here.

FIG. 16 is a schematic view of the projection exposure apparatus according to the present example. In FIG. 7, a wavelength-selective aperture stop 243, which is similar to the aperture stop 237 of FIG. 14A, is placed near the pupil surface PS of the projection optical system 212 located between upper lens system 212A and lower lens system 212B. Illumination light IL2A of wavelength λ2 (to which the photoresist is not sensitive) from light source unit 202A, and illumination light IL1A of wavelength λ1 (to which the photoresist is sensitive) from light source unit 201A are combined by polarization beam splitter 231 and pass through reticle 210. The thus combined light undergoes optical Fourier transformation in upper lens system 212A of projection optical system 212 and is incident on aperture stop 243.

As in the aperture stop 237 of FIG. 14A, the aperture stop 243 includes an annular optical filter that passes only the illumination light IL1A (capable of exposing the photoresist on the wafer) and a circular optical filter that passes only the illumination light IL2A (incapable of exposing the photoresist). Accordingly aperture stop 243 functions as a center-blocking type pupil filter with respect to illumination light IL1A. The other illumination light IL2A passes through the circular area that blocks illumination light IL1A, and enters the lower lens system 212B to illuminate wafer 213.

In this modified second example, aperture stop 243, placed at the pupil surface PS of projection optical system 212, provides the same high resolution realized in the second example of FIG. 15. Also, the glass material in lower lens system 212B is illuminated with uniform intensity distribution by combined illumination light of two wavelengths (IL1B and IL2B). Therefore, high order spherical aberration fluctuations can be suppressed. To achieve the most effective reduction of high order spherical aberration fluctuations, the filter that is transparent with respect to illumination light IL1A from light source 201A preferably has the lowest possible transmissivity for illumination light IL2A from light source unit 2A. Moreover, as in the example of FIG. 13, a dichroic mirror may be used in place of polarization beam splitter 231.

Next we will describe the effects of the above-described examples by presenting sample calculations

## Sample Calculations II

The post-rise temperature distributions (the temperature distribution after the temperature rises due to illumination by illumination light) are computed in the various conditions. For the sake of these calculations, the followings are assumed: The lens is approximated as a cylinder. No heat is conducted away from the surfaces of the lens through the air. Heat flows out of the lens only through its edges contacting metal. The absorption energy density distribution in the lens has rotational symmetry around the optical axis AX. If the radial distance of the lens is expressed by variable r, the post-rise temperature distribution will be a function of the variable r, $T(r)$. Then, if the amount of heat absorption per unit volume and the thermal conductivity of the lens are $\omega(r)$ and $\lambda$, respectively and the outer radius of the lens is $\alpha$, the heat conduction equation in thermal equilibrium is expressed by the following equation in cylindrical coordinate system:

$$\frac{\partial^2 T}{\partial r^2} + \frac{1}{r}\frac{\partial T}{\partial r} + \frac{\omega(r)}{\lambda} = 0. \tag{7}$$

Solving this equation yields the following equation:

$$T(r) = \sum_{i=1}^{\infty} B_i \cdot J_0(p_i \cdot r) \; ----------- \tag{8}$$

Here, $J_n(p_i \cdot r)$ is the n order (n = 0, 1, 2, ...) Bessel function of the first kind, and $p_i$ is a series satisfying the expression $J_0(p_i \cdot a) = 0$, where i = 1, 2, 3, ... . The coefficients $B_i$ are determined by the following equation:

$$B_i = 2 \frac{\int_0^a (\frac{\omega(r)}{\lambda}) \, J_0(p_i \cdot r) \, rdr}{p_i^2 \cdot a^2 [J_1(p_i \cdot a)]^2}. \quad \text{---------} \quad (9)$$

In particular, when the amount of heat absorption $\omega(r)$ is expressed as a step function within the radius of the illuminated area (illumination radius), i.e., for each annular region $h_j < r < h_{j+1}$ ($1 \le j \le N$), $\omega(r)=\omega_j$ (constant), the following relationship is satisfied:

$$\int_0^a \omega(r) \, J_0(p_i \cdot r) \, rdr = \sum_{j=1}^N \int_0^a \omega_j \, J_0(p_i \cdot r) \, rdr$$

$$= \sum_{j=1}^N \omega_j [h_{j+1} \cdot J_1(p_i \cdot h_{j+1}) - h_j \cdot J_1(p_i \cdot h_j)]/p_i \quad \text{-----------} \quad (10)$$

Therefore, the value of coefficient $B_i$ can be determined by inserting equation (10) into equation (9), and that value of $B_i$ can then be inserted in equation (8) to find the post-rise temperature distribution T(r).

Next, to determine which order of aberration distribution is dominant, the post-rise temperature distribution T(r) is expanded into a power series of r (up to $r^{10}$ term) using the least squares method. This yields the following equation:

$$T(r) = T_0 + C_2 \cdot r^2 + C_4 \cdot r^4 + C_6 \cdot r^6 + C_8 \cdot r^8 + C_{10} \cdot r^{10} \quad (11)$$

In this equation, the post-rise temperature distribution T(r) is given in the unit of "°C", and the variable r is given in the unit of "mm". Also, $T_0$ is the post-rise temperature distribution T(0) at the optical axis AX, i.e., at r=0.

The following explanation is based on sample calculations using actual numerical values. The "coherence factor" (the ratio between the numerical apertures (NA) of the exit-end of the illumination optical system and the entrance-end of the projection optical system) $\sigma$ is set to 0.75. The calculations are based on the solutions of heat conduction equations (8) - (10) in the case that a cylindrical quartz lens has the radius of 40 mm and is illuminated by an illumination system having a $\sigma$ of 0.75, and the radius of the illuminated area on the lens d is 30 mm. It is assumed that a coefficient of thermal conductivity for quartz is 0.0138W/(cm $\cdot$ °C), and the lens coefficient of thermal absorption coefficient of the lens with respect to exposing illumination light (to which the photoresist on the wafer is sensitive) is 2%/cm.

First, for comparison, the following computation is performed for the case that illumination light has total illumination energy of 1W, the $\sigma$ value is 0.75, and the lens is uniformly illuminated, as a first computation example.

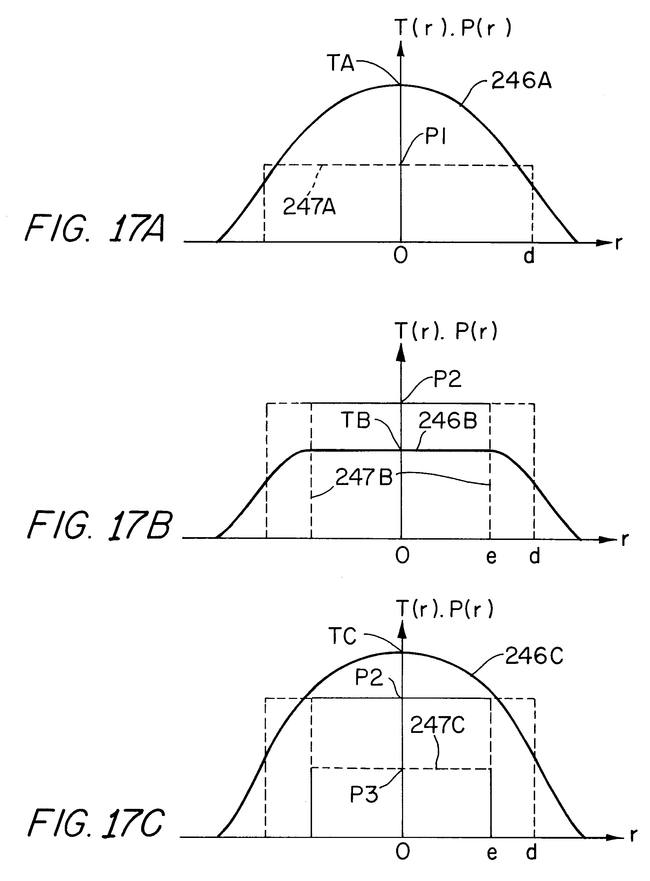

FIG. 17A shows the result of the first computation example for the post-rise temperature distribution T(r). In FIG. 17A, the horizontal axis indicates the variable r, and the vertical axis indicates the post-rise temperature distribution T(r). As shown by solid line curve 246A, the post-rise temperature distribution T(r) has its maximum value at the origin (optical axis AX), and exhibits a rounded-hill-shaped distribution that is axially symmetric about optical axis AX. For reference, the illumination energy density distribution P(r) of the illumination light is shown by dotted line 247A. The illumination energy density distribution P(r) is constant for the r range between 0 and d (the illumination radius). Table 5 lists coefficients $C_2$ - $C_{10}$ together with the temperature $T_0$ at optical axis AX when temperature distribution T(r) are expanded into a power series of equation (11).

Table 5

| T<sub>0</sub> (Post-Rise Temperature at the Optical Axis) | $1.8182 \times 10^{-1}$ |
|---|---|
| coefficient: | |
| $C_2$ | $-1.3450 \times 10^{-4}$ |
| $C_4$ | $4.4000 \times 10^{-8}$ |
| $C_6$ | $-9.9006 \times 10^{-11}$ |
| $C_8$ | $8.2983 \times 10^{-14}$ |
| $C_{10}$ | $-2.0745 \times 10^{-17}$ |

Next, a second computation example will be described. This computation example applies when only annular illumination is used (without applying the present invention). Like the first computation example, it is provided for comparison. The post-rise temperature distribution T(r) is computed under the following conditions: the maximum value of $\sigma$ is 0.75, the value of $\sigma$ for inner circle defining the annular ring is 0.5, the illumination of the lens is uniform within a range of $\sigma$ = 0.5 - 0.75, and the total illumination energy is 1W.

FIG. 17B shows the post-rise temperature distribution T(r) obtained by this second computation example. As shown by solid line curve 246B in FIG. 17B, the post-rise temperature distribution T(r) has a nearly constant temperature distribution TB between r values of 0 to e. The illumination energy density P(r), shown by dotted line 247B, is constant P2 between r values of e to d, and is 0 between r values of 0 to e. As in the first computation example, coefficients $C_2$ - $C_{10}$ are obtained by expanding T(r) in to a power series using equation (11). The results are shown in Table 6 below.

Table 6

| T<sub>0</sub> (Post-Rise Temperature at the Optical Axis) | $1.0744 \times 10^{-1}$ |
|---|---|
| coefficient: | |
| $C_2$ | $-3.4231 \times 10^{-5}$ |
| $C_4$ | $2.7328 \times 10^{-7}$ |
| $C_6$ | $-6.3961 \times 10^{-10}$ |
| $C_8$ | $4.5319 \times 10^{-13}$ |
| $C_{10}$ | $-1.0513 \times 10^{-15}$ |

Next, a third computation example will be described. In this computation example, the post-rise temperature distribution T(r) is computed in the case that the lens is illuminated by two illumination light beams having different wavelengths (one to which the photoresist on wafer 213 is sensitive, and the other to which it is not sensitive), as in the cases of above examples according to the present invention shown in FIGs. 10, 13, 15, and 16. For $\sigma$ value in the range of 0.75 to 0.5, it is assumed that the lens be uniformly illuminated by exposing illumination light with total illumination energy of 1W (by light to which the photoresist is sensitive), and for $\sigma$ values in the range of 0.5 to 0.0, it is assumed that the lens be uniformly illuminated by light having a different wavelength by which the photoresist is not exposed. The illumination energy density distribution P(r) for the orange of 0.5 to 00 is chosen to be half of that for the $\sigma$ range of 0.75 to 0.5.

FIG. 17C shows the post-rise temperature distribution T(r) obtained by the third computation example. As shown by solid line curve 246C in FIG. 17C, the post-rise temperature distribution T(r) has its maximum value TC at the origin (optical axis AX), and exhibits a rounded-hill-shaped variation that is axisymmetric about the optical axis AX. For reference, Illumination energy density P(r) is shown by the dotted line 247C. The P(r) has the step-shaped distribution with a constant value P2 between r value of e from d and constant value P3 (= P2/2) between r values of 0 and e. The coefficients $C_2$ - $C_{10}$ obtained by expanding the temperature distribution T(r) in to a power series together with temperature

$T_0$ at optical axis AX using equation (11) are listed in Table 7 below.

Table 7

| $T_0$ (Post-Rise Temperature at the Optical Axis) | $2.1736 \times 10^{-1}$ |
|---|---|
| coefficient: | |
| $C_2$ | $-1.3821 \times 10^{-4}$ |
| $C_4$ | $1.7624 \times 10^{-7}$ |
| $C_6$ | $-4.0891 \times 10^{-10}$ |
| $C_8$ | $3.0128 \times 10^{-13}$ |
| $C_{10}$ | $-7.1235 \times 10^{-17}$ |

In the first and second computation examples above, the total illumination energy is 1W, whereas in the third computation example, the illumination energy of 1W is applied for the range of $\sigma$ values between 0.75 and 0.5. In this third computation example, since the illumination energy within a range of $\sigma$ values of 0.5 - 0.0 is added, the total illumination energy exceeds 1W. This is because, in this way, the amount of illumination energy for exposing illumination light (light to which the photoresist on wafer 213 is sensitive) becomes the same in all of the three computation examples above. Therefore, the exposure time (throughput) is the same for all examples.

Comparing the results of the first example (uniform illumination) and the second example (annular illumination) in Tables 1 and 2, it is seen that temperature at the optical axis AX in the case of annular illumination is lower than that for uniform illumination. Nonetheless, coefficient $C_4$ in annular illumination is larger than that in uniform illumination ($2.7328 \times 10^{-7}$ for annular, compared to $4.4000 \times 10^{-8}$ for uniform illumination). In fact, except for $C_2$, the absolute values of all power series coefficients in annular illumination are larger than those for uniform illumination. Since fluctuations in thermal distortion and index of refraction are proportional to post-rise temperature distribution T(r), fluctuations in aberrations are also proportional to post-rise temperature distribution T(r). That is, for orders of power series coefficients higher than $C_2$, the coefficients are all larger for annular illumination. This explains why fluctuations in the high order aberrations with annular illumination are greater than that for normal illumination.

When the third computation example of "composite illumination" according to the present invention (as shown in FIGs. 10, 13, 15, and 16) is used to illuminate the area near the optical axis, the total amount of illumination becomes larger than that with uniform illumination or annular illumination, as shown in Tables 1 and 2. Nevertheless, the value of the $C_4$ coefficient with composite illumination ($C_4 = 1.7624 \times 10^{-7}$) is smaller than that for annular illumination ($C_4 = 2.7328 \times 10^{-7}$). In addition, the absolute values of coefficients $C_6$, $C_8$, and $C_{10}$ with composite illumination are smaller than those obtained in the case of annular illumination. This explains why fluctuations in the high order aberrations are smaller with composite illumination.

In the third computation example, the illumination energy density at $\sigma$ values between 0 and 0.5 is one-half of the illumination energy density at $\sigma$ values of 0.5 and 0.75. In the following, another calculation for T(r) will be presented for the case that the lens is uniformly illuminated in the entire $\sigma$ range of 0 - 0.75 by increasing illumination energy density P3 in the third example, and the results are compared with the case of annular illumination of FIG. 17B.

The total amount of illumination TP (W) which illuminates lenses in this case can be obtained by following equation.

$$TP = (1\ W \cdot 0.75^2/(0.75^2 - 0.5^2) = 1.8W$$

Therefore, the relationship between illumination energy density P1 in FIG. 17A and P2 in FIG. 17B is such that $P2 = 1.8 \cdot P1$. Accordingly, if illumination with the same illumination energy density as in the annular illumination area of FIG. 17B is performed even at the $\sigma$ value range of less than 0.5, this situation is equivalent to illumination energy density of FIG. 17A except that the energy density needs to be multiplied by 1.8. Therefore, since the power series coefficients are all increased by a factor of 1.8, the resulting values of coefficients $C_4$, $C_6$, $C_8$ and $C_{10}$ become $7.9200 \times 10^{-8}$, $-1.7821 \times 10^{-10}$, $1.4937 \times 10^{-13}$, and $-3.7341 \times 10^{-17}$, respectively. When these coefficient values are compared with the respective values in Table 6, it is seen that although the post-rise temperature $T_0$ at the optical axis AX is quite larger than that in the case of annular illumination, the coefficients $C_4$ through $C_{10}$ are all smaller than those with annular illumination. In other words, when illumination is performed with composite light and the inside of the annular region ($\sigma$ range of 0 - 0.5) is illuminated with the same illumination energy density as that in annular region (P2), the fluctuations in higher order aberrations still become smaller than those in the case of annular illumination.

In the above examples, the present invention is applied to a stepper-type projection exposure apparatus. The invention may also be applied to scanning-type projection exposure apparatus ("step-and-scan" systems, etc.).

The first example of the second embodiment of the projection exposure apparatus according to the present invention uses exposing illumination light from a light source such that the exposing illumination light is distributed over areas that are eccentric with respect to the optical axis at a plane that is conjugate with the pupil surface of the projection optical system. Because of this, improvement in resolution is achieved in a similar manner as in annular illumination and/or modified illumination. Also, when performing such effective annular illumination or modified illumination of the present invention, the area of the optical system, through winch the exposure illumination light does not pass, is illuminated by another illumination light that does not expose the photoresist. This reduces high order thermal distortion and index of refraction fluctuations of the projection optical system lens, thereby suppressing fluctuations in the high order spherical aberrations in the projection optical system.

Also, when the illumination optical system has an optical integrator to make the illumination distribution of the exposure illumination light uniform and auxiliary light input member between the optical integrator and the mask for guiding the illumination light from the auxiliary illumination system onto the mask, the mask can be illuminated by both exposing illumination light and the illumination light that does not expose the photoresist in a precisely separated manner at a plane that is conjugate with the pupil surface. Thus, this provides an advantage in that imaging characteristics are not degraded.

Also, the projection exposure apparatus according to the second embodiment of the present invention uses imaging beams that are formed through an optical member that has wavelength selectivity and is positioned at the pupil surface of the projection optical system. The imaging beams are formed to pass through areas at the pupil surface of the projection optical system that are eccentric with respect to the optical axis. The advantage of this is that it provides the same improvement in resolution as in the cases of installing an annular, center-blocking type pupil filter. In addition, lenses near the pupil surface of the projection optical system are illuminated with consistent illumination intensity distribution by two types of illumination light (the exposure light and light to which the photosensitive substrate is not sensitive). This provides advantages in that fluctuations in thermal distortion and the index of reflection in the lens can be reduced, and that fluctuations in the high order spherical aberrations of the projection optical system can be reduced.

In the first example of the second embodiment of the present invention, this use of exposure illumination light (IL1) from a light source distributed over areas that are eccentric with respect to optical axis (AX) and lies in a plane that is conjugate with the pupil surface (PS) of projection optical system (212) is essentially the same as using an annular or modified illumination method. Therefore, high resolution can be obtained for a predetermined periodic pattern, for example.

Also, because an area of the pupil surface (PS) of the projection optical system (212) that does not pass the exposure illumination light (IL1) is illuminated by illumination of light (IL2) from an auxiliary illumination system (202), to which the photosensitive substrate (213) is not sensitive, the illumination intensity distribution for lenses near the pupil surface (PS) of the projection optical system (212) becomes uniform, thereby reducing high order fluctuations in thermal deformation and the refraction index of the lens. In this case, it is preferable that the non-sensitive (non-exposing) light (IL2) is absorbed by the lens in the projection optical system (212) and/or the coating films thereof, at roughly the same absorption rate as exposure illumination light (IL1). The fluctuations in spherical aberration of the lens are proportional to fluctuations in the thermal deformation and the index of refraction of the lens, thus suppressing the fluctuations in high order spherical aberration of the projection optical system (212). Because photosensitive substrate (213) is not exposed by illumination light (IL2) from the auxiliary illumination system (202), this light has no affect on the image to be transferred.

In this case, with this illumination optical system, it is preferable to illuminate the mask (210) with exposure illumination light (IL1) from either an annular light source, or from multiple light sources positioned eccentric to the optical axis (so-called annular and modified illumination methods used to improve resolution). This illumination optical system also has an optical integrator (224) to produce uniform intensity distribution of the exposing illumination light (IL1). It is preferable to provide, between this optical integrator and the mask (210), an auxiliary light input members (204, 206A - 206D, 207A, and 207B) to guide illumination light (IL2) from the auxiliary illumination system (202) to the mask (210). This facilitates the combining of the exposure illumination light (IL1) with the auxiliary illumination light (IL2).

This second example of the second embodiment of the present invention uses imaging beams that passes through areas that are eccentric with respect to the optical axis (AX) at the pupil surface (PS) of the projection optical system (212). This improves resolution, because it is essentially the equivalent to using a center-blocking pupil filter. In this system, due to optical member (205B), exposure illumination light (IL1B) passes through only the area of annular shape, etc., while "non-sensitive" illumination light (IL2B) passes the inside of the areas that are eccentric with respect to the optical axis. Accordingly, lenses in the vicinity of the pupil surface (PS) of the projection optical system (212) is illuminated with uniform illumination intensity distribution by the two illumination light beams (1LB1 and ILB2). This suppresses fluctuations in high order spherical aberrations due to fluctuations in thermal deformation and the index of refraction of the lens. Moreover, the "non-sensitive" illumination light (IL2B) has no influence on the image to be projected onto the photosensitive substrate (213).

## Third Preferred Embodiment

**First example**

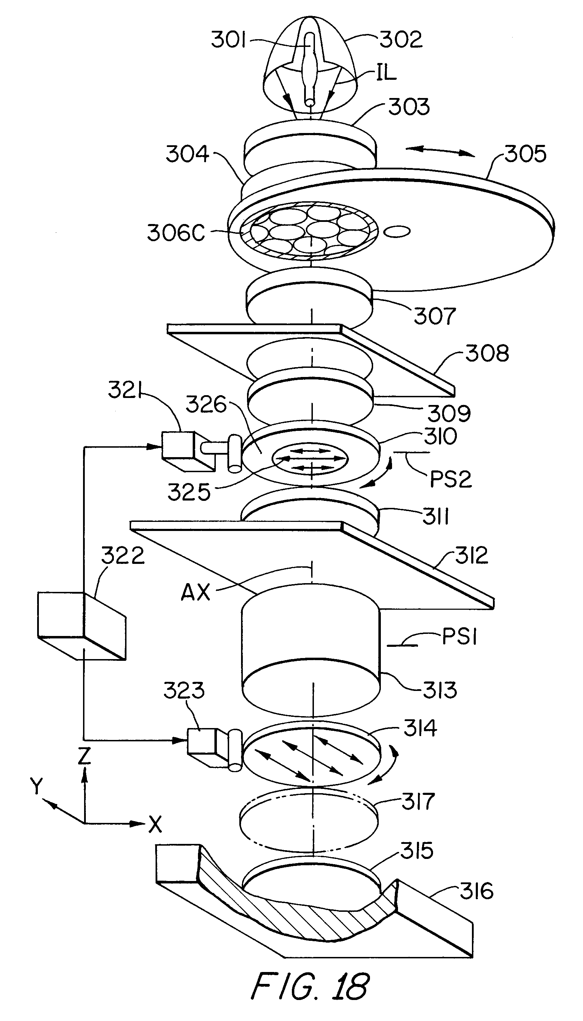

In the following, an projection exposure apparatus according to a first example of a third embodiment of the present invention will be described with reference to FIGs. 18 through 20C. This example is one in which the present invention is applied in a "stepper" type projection exposure system that projects a reticle pattern onto the shot area of a wafer through projection optical system.

FIG. 18 is a schematic view showing the configuration of the projection exposure apparatus according to this example. In FIG. 18, illumination light IL, which can expose the photoresist on the wafer 315, is emitted from a light source 301 (a mercury vapor lamp, for example) and is condensed by oval mirror 302. It then enters input lens 303 and an interference filter not illustrated. The illumination light IL of the i-line (wavelength 365nm), for example, is extracted by the interference filter. Other than the i-line, the emission lines (e.g., the g-line), excimer lasers (e.g. ArF, KrF), and the harmonies of laser light of a copper vapor laser or YAG laser may be used as the exposing illumination light IL1.

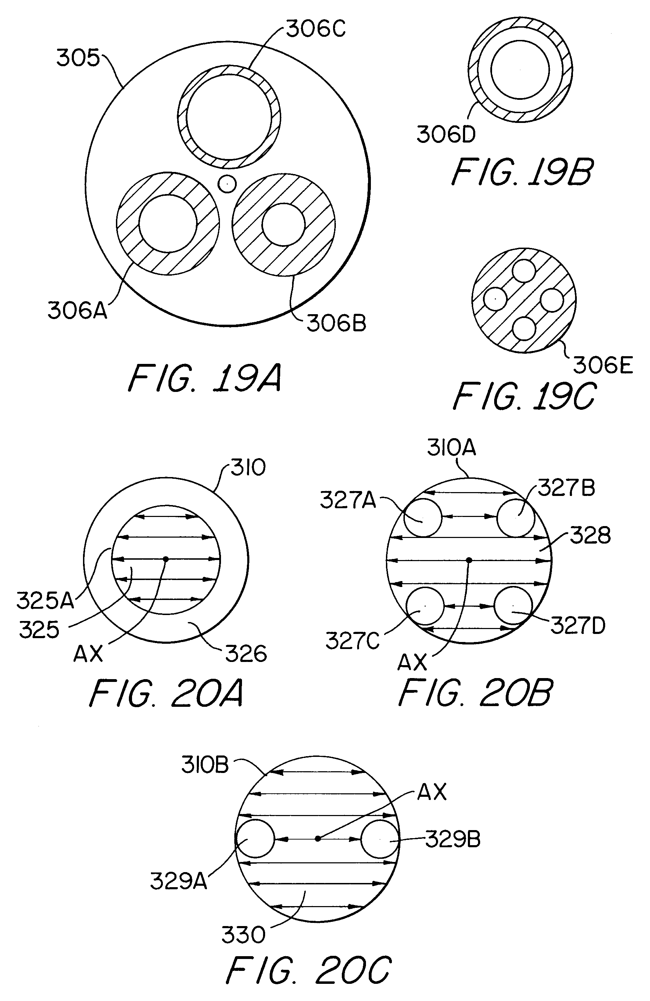

Illumination light IL1 is formed into a collimated beam by input lens 303 and is incident on fly-eye lens 304, which acts as an optical integrator. Each of the exit surfaces of the lens elements of the fly-eye lens 304 can be regarded a secondary light source, and these secondary light sources together form a planar light source. A plurality of aperture stops 306A - 306C (FIG. 19A) for adjusting the illumination size of the planar light sources are placed on the exit surface of the fly-eye lens 304. These aperture stops 306A - 306C are fixed to a turret-type turntable 305, which can be rotated by drive unit (not illustrated) to set the desired aperture stops in front of the exit surface of fly-eye lens 304.

FIG. 19A is a plan view showing a specific configuration of the aperture stops in turntable 305 of FIG. 18. In FIG. 19A, three aperture stops, 306A - 306C are spaced at equal intervals (equal angular intervals) around the periphery of turntable 305. First aperture stop 306A has a circular aperture that is used for normal illumination. Second aperture stop 306B has small circular aperture used for illumination with a small coherence factor ($\sigma$ value). Aperture stop 306C has a largest circular aperture. In the present example, when annular illumination or modified illumination is performed, this third aperture stop 306C is positioned in front of the exit plane of fly-eye lens 304. In the conventional annular illumination method, annular aperture stop 306D shown in FIG. 19B is used, while in the conventional modified illumination, aperture stop 306E, which has four small apertures centered around the optical axis, as shown in FIG. 19C, is used. In this example of the present invention, however, partial polarization plate 310 (to be described later) is used to perform annular and modified illumination instead of aperture stop 306D, etc. In FIG. 18, the aperture stop 306C is placed in the light path of the illumination light IL1.

Referring to FIG. 18, illumination light IL that has passed through aperture stop 306C enters first relay lens 7. Field stop (reticle blind) 308 further defines the illumination area. Once the illumination area is defined, illumination light IL enters partial polarization plate 310 through second relay lens 309. Illumination light IL that enters the partial polarization plate 310 is a so-called "random polarized" beam consisting of a randomly polarized component as in natural light A plane PS2, in which partial polarization plate 310 is placed, is conjugate with the position of the aperture stop 306C and is referred to as "illumination system pupil surface".

FIG. 20A is a plan view of partial polarization plate 310. In FIG. 20A, the center of the partial polarization plate 310 is arranged to substantially coincide wish the optical axis AX. Circular region 325 around the optical axis AX is a linear polarized plate that only transmits the components of light that is polarized in a direction indicated by the arrows in FIG. 20A; it produces linearly polarized light out of randomly polarized light. In other words, of illumination light IL entering the region 325, only the linearly polarized component (in the direction of the arrows) passes through the region 325. Note that arrows indicate the direction in which electric vectors work. (This is always the case in the following description.) The partial polarization plate 310 transmits illumination light IL through an annular shaped region 326 located outside the circular region 325 and circle 325 A. The illumination light IL passes through the annular region 326 as randomly polarized light without any changes in its polarization condition. The outer circle of the annular shaped region 326 is designed such that it is larger than the outer circle of the image of the aperture in aperture stop 306C shown in FIG. 18. Also, as shown in FIG. 18, partial polarization plate 310 is 180° rotatable around the optical axis AX, and its rotation angle around the optical axis AX is controlled by rotation angle controller 322 through rotation driver 321. In addition, the partial polarization plate 310 can be replaced with other partial polarization plate for a modified illumination technique via the rotation driver 321. Also, the partial polarization plate 310 can be removed from the optical path of illumination light IL, if necessary.

FIGs. 20B and 20C show partial polarization plates for use with a modified illumination technique. In FIG. 20B four circular apertures 327A through 327D are formed near the circumference of the partial polarization plate at equal angular intervals. The region 328 around the circular apertures is a polarized plate that transmits the components of light that is linearly polarized in a direction Indicated by the arrows. If the center of the partial polarization plate 310A is placed to coincide with the optical axis AX of the illumination optical system shown in FIG. 18, randomly polarized illumination light IL passes through the four circular apertures 327A through 327D, which are eccentric to the optical axis AX. On the other hand, only the linearly polarized components pass through the region 328.

As shown in FIG. 20C, a partial polarization plate 310B has two apertures 329A, 329B on both ends. The components of light that is linearly polarized in the arrow direction can pass through the region 330 surrounding these apertures. The unpolarized beams, which pass through the apertures 329A, 329B, maintain their random polarized state. These partial polarization plates 310A, 310B are also rotatable by the rotation driver 321.

In FIG. 18, illumination light IL that has passed through partial polarization plate 310 and has random and linear polarized components illuminates reticle 312 through condenser lens 311. Illumination light IL that illuminates reticle 312 passes through a pattern region on reticle 312 to enter polarization plate 314 via projection optical system 313. The polarization plate 314 is oriented in such a way as to pass only the components of light that is linearly polarized in a direction perpendicular to the polarization direction defined by the circular region 325 of partial polarization plate 310. Therefore, the linearly polarized components that have passed through circular region 325 of partial polarization plate 310 is blocked by the polarization plate 314.

Of randomly polarized components of light that has passed through the annular (ring-belt shaped) region 326 of partial polarization plate 310, only the linear polarized component, which is parallel to the polarized direction of polarization plate 314, can pass through polarization plate 314 to illuminate wafer 315. The patterned surface of the reticle 312 is conjugate with the surface of wafer 315 with respect to projection optical system 313 under illumination light IL. The illumination light IL that passes through the polarization plate 314 transfers the image of the reticle pattern on reticle 312 onto wafer 315.

Polarization plate 314 is 180° rotatable around the optical axis AX in a similar manner to the partial polarization plate 310. The rotation angle of polarized plate 310 around the optical axis AX is controlled by rotation angle controller 322 through rotation driver 321. Relative angular relationship between partial polarization plate 310 and polarization plate 314 is maintained such that the polarized directions are perpendicular to each other. Thus, both plates are synchronously rotated, if necessary. Here, pupil surface PS 1 of the projection optical system 313, i.e., the optically Fourier transformed plane of the pattern surface of the reticle 312 is conjugate with each of the installation plane of aperture stop 306C and the pupil surface PS 2 of the illumination system, at which partial polarization plate 310 is placed.

In FIG. 18, the optical axis AX of the illumination optical system coincides with that of projection optical system 313. In the following description, the Z axis is taken parallel to the optical axis AX, the X axis is taken parallel to the paper of FIG. 18 and perpendicular to the Z axis, and the Y axis is taken perpendicular to the X and Z axes.

Reticle 312 is mounted on a reticle stage (not illustrated), which is movable by a small amount in the X, Y, and rotation directions. The accurate position of the reticle 312 is measured by externally installed laser interferometers (not illustrated), and the position of retide 312 is controlled based on these laser interferometer measurements. Wafer 315 is mounted via a wafer holder (not illustrated) on wafer stage 316, which positions the wafer in the X, Y, and Z directions. The accurate position of wafer stage 316 is measured by externally installed interferometers, and the positian of wafer stage 316 is controlled based on these laser interferometer measurements. The operation of wafer stage 316 for aligning the center of each shot area of wafer 315 with the center of exposure of projection optical system 313 and the exposure operation itself are repeated in a step-and-repeat technique to transfer the image of the pattern on reticle 312 onto all the shot areas of wafer 315.

The operation of the projection exposure apparatus of the present example will now be explained. First, as shown in FIG. 18, aperture stop 306C having a large aperture is placed at the outgoing plane of lens 304 and partial polarization plate 310 is placed at the optical path of illumination light IL by rotation driver 321. Illumination light IL emitted from fly-eye lens 304 includes all polarization components. Of illumination light IL, the linearly polarized components can pass through the region 325 of the partial polarization plate 310, which is placed at illumination system pupil surface PS 2. Also, illumination light IL is transmitted by the annular shaped region 326 located near the periphery of the partial polarization plate 310 as randomly polarized beams. In other words, the components of the illumination light IL that correspond to a numerical aperture at illumination system pupil surface PS 2 smaller than a predetermined value is linearly polarized. When the reticle 312 is illuminated with such illumination light IL including randomly polarized beams and linearly polarized beams, the linear polarized beams illuminate the center portion of the lenses located near the pupil surface PS1 of the projection optical system 313. Therefore, since illumination energy is absorbed in the center portion of the lens, temperature rises not only at the periphery but also at the center portion of the lens. This increases the second order component relative to the higher order components in fluctuations in the index of refraction and thermal deformation of lenses. As a result, the higher order fluctuations in spherical aberrations can be suppressed.

Polarization plate 314, whose polarized direction is perpendicular to that of region 325 of partial polarization plate 310, is arranged between the projection optical system 313 and wafer 315. The linearly polarized component, which is selected by circular region 325 of partial polarization plate 310, is blocked by the polarization plate 314, and therefore, does not form any image on the wafer 315.

Since the polarization plate is installed between the projection optical system 313 and the wafer 315 to block the components of illumination light IL that have passed through the center region 325 of the partial polarization plate 326, these components of illumination light IL do not contribute to image formation on the wafer 315. On the other hand, the components of illumination light IL that have passed through the annular region 326 of the partially polarized plate 310 and the polarization plate 314 contribute to the image formation on the wafer 315. As a result, an illumination condition that is essentially equivalent to the annular illumination technique using aperture stop 306D of FIG. 19B is obtained.

In this case, the components of illumination light IL that can contribute the image formation on wafer 315 is linearly polarized. Abnormality in the images of lines on the wafer 315 may occur due to use of such linearly polarized light. For example, the line width of a line-and-space pattern may vary with the angle between the lines and the polarization direction of illumination light IL. To avoid this problem, during exposure, the rotation controller 322 synchronously rotates partial polarization plate 310 and polarization plate 314 via rotation drivers 321 and 323 while maintaining the directions of polarization perpendicular to each other. That is, during exposure, partial polarization plate 310 and polarization plate 314 are rotated by 180°. This way, above-mentioned possible problew can be solved.

Instead of having mechanisms for rotating partial polarization plate 310 and polarization plate 314, a quarter wavelength plate 317, which converts linearly polarized beams to circular polarized beams, may be installed on the optical path of illumination light between polarization plate 314 and wafer 315, as indicated by the two dotted chain lines in FIG. 18. This technique eliminates the above-mentioned possible problem of the abnormal line width. With this technique, the circular polarized imaging beam illuminates the wafer 315. Also, a half wave length plate may be rotatably installed instead of the quarter wavelength plate 317. In these cases, partial polarization plate 310 and polarization plate 314 do not require rotation mechanisms; i.e., rotation drivers 321, 323 and rotation controller 322 in FIG. 18 are not needed.

Also, as described above, it is preferable that polarization plate 314 is installed between projection optical system 313 and wafer 315 so that all the lenses in the projection optical system 313 are illuminated with the linearly polarized component that has passed through region 325 of partial polarization plate 310. However, uneven distribution of illumination intensity over the lenses that are located near the pupil surface PS1 of the projection optical system 313 mainly contribute to fluctuations in thermal deformation and the index of refraction, which in turn cause fluctuations in spherical aberration. Therefore, considerable effects can be obtained even if polarization plate 314 is installed at some place after the pupil surface PS 1 inside the projection optical system 313 at the wafer side.

As described above, since the partial polarization plate 310 is installed at the pupil surface PS2 of the illumination optical system, the centers of the lenses located near the pupil surface PS1 of projection optical system 313 are illuminated with linearly polarized beams and the peripheries thereof are illuminated with randomly polarized beams. Randomly polarized beams can be regarded as a combination of two orthogonal linearly polarized beams. Therefore, at the center of the lens near pupil surface PS 1, illumination energy density is about a half of that at the periphery. If because of this, the high order spherical aberrations cannot be made small enough, illumination intensity needs to be reduced at the annular shaped region 326 of the partial polarization plate 310. To do this, an ND filter (Neutral Density filter), which can reduce light intensity, may be placed at the annular shaped region 326.

Next, the case of performing the modified illumination technique is explained. The partial polarization plate 310A of FIG. 20B or partial polarization plate 310B of FIG. 20C is placed at the optical path of illumination light IL1 via rotation driver 321 shown in FIG. 18. The linearly polarized components of illumination light IL that have passed through region 328 (excluding four apertures 327A to 327D) of partial polarization plate 310A or region 330 (excluding two apertures 329A, 329B) of parallel polarized plate 310B, illuminate the center portions of the lenses located near the pupil surface PS1 of the projection optical system 313 of FIG. 18. This reduces high order spherical aberrations. Also, since the linearly polarized components are blocked by polarization plate 314, this illumination condition is substantially equivalent to the conventional modified illumination technique. This provides high resolution for predetermined periodic patterns.

Particularly, when using partial polarization plate 310B shown in FIG. 20C, there are situations in which better resolution can be obtained than using four apertures of FIG. 20B. That is, use of the partial polarization plate 310B produces linearly polarized beams that are obliquely incident on the wafer 315 in the respective directions perpendicular to the polarized direction. If a mechanism for rotating the partial polarization plate 310B at least 180° per exposure is provided, illumination beams are directed perpendicular to the polarized direction thereof with respect to periodic patterns of any directions. This illumination configuration improves resolution in a similar manner to the case that the annular polarization plate, which polarizes light in annular direction perpendicular to the radial direction, is installed in the illumination optical system (this technique is described in Japanese patent Laid-Open publication No.06-53120). The effects of this technique are described in the Japanese patent Laid-Open publication No. 06-53120 in detail.

When using a normal illumination technique, aperture stop 306A or 306B shown in FIG. 19A is placed in from of the emission plane of fly-eye lens 304. At the same time, partial polarization plate 310 (or 310A, 310B) is moved away from the optical path of illumination light IL. In addition, polarization plate 314 may be moved away. This provides a normal illumination configuration.

In the above first example, polarization beam splitters may be used in place of partial polarization plate 310 and polarization plate 314. If a polarization beam splitter is used in place of circular region 325 of partial polarization plate 310, no equipment may be placed in the region corresponding to the annular region 326.

**Second example**

Next, a projection exposure apparatus according to a second example of the third preferred embodiment is described. In this example, the present invention is applied to the case of using a center-blocked type pupil filter. Of components shown in FIG. 21, those that are the same as in FIG. 18 are labeled by the same reference numerals and the detailed explanations thereof are not repeated here.

FIG. 21 is a schematic perspective view showing a portion of a projection exposure apparatus according to the present example. In FIG. 21, reticle 312 is illuminated by illumination light IL from all illumination optical system (not illustrated in FIG. 21) that is the same as in FIG. 18 (including light source 301 through condenser lens 311) except partial polarization plate 310. In this example, partial polarization plate 310 is not placed in the illumination optical system. Thus, reticle 312 in FIG. 21 is illuminated by the randomly polarized illumination light IL.

For the purpose of simplifying the following description, projection optical system 313 is separated into upper lens system 313A and lower lens system 313B. As shown in FIG. 21, partial polarization plate 310C, which is similar to partial polarization plate 310 in FIG. 18, is placed near the pupil surface PS1 of projection optical system 313. Illumination light IL that has entered the upper lens system 313A through reticle 312 enters the partial polarization plate 310C. On the partial polarization plate 310C, circular region 325A around optical axis AX functions as a polarized plate which transmits the components of light that is linearly polarized in a direction indicated by the arrows of FIG. 21. Annular shaped region 326A, which surrounds the circular region 325A transmits randomly polarized beams as such. Of illumination light entering partial polarization plate 310C, the linearly polarized components, which have passed through region 325A, and randomly polarized beams, which have passed through region 326A, together enter the lower lens system 313B. Then, these light beams enter polarization plate 314, which is adapted to transmits the components of light linearly polarized in a direction orthogonal to the polarization direction of region 325A of partial polarization plate 310C. The image of the reticle pattern on reticle 312 is thus transferred onto the wafer 315 by the linearly polarized light that has passed through polarization plate 314. In this example also, the partial polarization plate 310C and the polarization plate 314 are 180° rotatable around the optical axis AX. They are synchronously rotated with each other while maintaining the orthogonal relation between the respective polarization directions.

In this second example, of imaging beams which entered projection optical system 313, only the linearly polarized component can pass through circular region 325A of partial polarization plate 310C. This linearly polarized component is blocked by polarization plate 314. Therefore, the configuration of the present example is equivalent to placing a pupil filter having a ring-belt shaped (annular) aperture at the pupil surface PS1 of the projection optical system 313. Therefore, this second example provides high resolution. Also, the center portions of the lenses in lower lens system 313B are illuminated with linearly polarized components of illumination light. Therefore, uneven illumination intensity distribution, which causes fluctuations in thermal deformation and the index of refraction in the lens, can be suppressed. As a result, the higher order aberration fluctuation components of the projection optical system 313 can be reduced.

In addition, partial polarization plate 310C and polarization plate 314 are 180° rotatable while maintaining the orthogonal relation between the respective polarization directions. Therefore, by synchronously rotating the polarization plates 310C and 314 by 180 degrees during exposure, the problem of abnormal line width, which depends on the direction of the periodic pattern, can be reduced. Here, as in the case of the first example of FIG. 18, a quarter wavelength plate may be placed at the optical path between polarization plate 314 and wafer 315 so that the linearly polarized beams created at polarization plate 314 are converted to circular polarized beams. This way, without having a mechanism for rotating partial polarization plate 310C and polarization plate 314, the problem of abnormal line width depending on the direction of the periodic pattern can be solved.

The effects of the above-described first and second examples of the third embodiment of the present invention can be demonstrated by sample computations as in the case of the sample calculation II for the second embodiment above. The second computation example of the sample calculation II above corresponds to the case of using the conventional annular illumination or pupil filter method in this third embodiment. The third computation example of the simple calculation II above corresponds to the case of using partial polarization plate 310 or 310C according to the third embodiment of the present invention.

The second part of the third computation example of the sample calculations II above, in which the lens is uniformly illuminated in the entire $\sigma$ range of 0 - 0.75 by increasing illumination energy density P3 of non-exposing illumination light by 1.8 times, corresponds to the case of using an ND filter or essentially corresponds to the case of using partial polarization plate 310A or 310B in the third embodiment of the present invention. Therefore, as demonstrated in the sample calculations II above, the third embodiment of the present invention is highly effective for suppressing the fluctuations in the higher order spherical aberrations except for the second order aberration which can be corrected by relatively simple manners.

The application of this third example of the present invention is not limited to the "stepper" type projection exposure apparatus. The present example may also be applied to a scanning-type projection exposure apparatus ("step-and-scan" systems, etc.). In scan-type systems, a part of a reticle pattern is projected onto a wafer via a projection optical system and is successively transferred onto each of the shot regions on the wafer by synchronizing the motions of the reticle and the wafer with respect to the projection optical system.

According to the projection exposure apparatus of the third embodiment of the present invention, since a portion of illumination light other than portions of the light that are obliquely incident on the mask or obliquely emitted from the mask is linearly polarized in a predetermined direction by a first polarization member. Then, such polarized light is blocked by a second polarization member. Therefore, the light beams that contribute to the image formation on the mask are those obliquely incident on or emitted from the mask. Thus, this technique is equivalent to the annular shaped illumination or modified illumination technique. The effective imaging beams and the beams which are polarized in the predetermined direction through the first polarization member together pass through the space between the first polarization member and the second polarization member. Therefore, the uniform illumination intensity distribution can be obtained in the lenses located near the pupil surface of the projection optical system placed between the first polarization member and the second polarization member. This reduces the higher order fluctuations in thermal deformation and the index of refraction in the lenses in the projection optical system. As a result, fluctuations in the high order spherical aberrations in the projection optical system can be effectively reduced.

Also, when the first polarization member sets a given polarized direction for illumination light that passes through the region inside the annular region around the optical axis or the regions excluding a plurality of regions which are eccentric to the optical axis, the effective imaging beams pass through the annular region around the optical axis or a plurality of regions eccentric to the optical axis. The thus produced effective imaging beams then pass through the second polarization member to form the image on the photosensitive substrate. On the other hand, the beams other than the effective imaging beams are blocked by the second polarization member. These beams do not form the image on photosensitive substrate. Therefore, placing the first polarization member at a plane which is conjugate with the pupil surface of the projection optical system is equivalent to the case of using the center-blocked pupil filter.

Moreover, a driver unit for rotating the first polarization member and the second polarization member while maintaining a predetermined relative angular relationship may be provided. In this case, by rotating the first polarization member and the second polarization member during exposure, the possibility of generating abnormal line width in the image of a line pattern can be minimized.

Furthermore, a third polarization member, which converts the illumination light that has passed through the second polarization member into circular polarized light, may be provided between the second polarization member and the photosensitive substrate. In this case, the possibility of generating the abnormal line width on the image can be minimized without the driver unit for rotating the first and second polarization members.

In a projection exposure apparatus according to the third embodiment of the present invention, when using the beams going out at an angle from mask (312) as effective imaging beams, first polarization member (310C) functions as equivalent of having a center-blocked type pupil filter installed at the pupil surface. On the other hand, when using the beams entering at an angle onto mask (312) as effective imaging beams, first polarization member (310 or 310A) is arranged within the illumination optical system in a conjugate relationship with the pupil surface of the projection optical system. In this way, the mask is illuminated with a substantially annular shaped illumination or modified-illumination technique.

Also, the effective imaging beams and the beams which are polarized in a given direction by the first polarization member are combined and together pass the space between the first polarization member (310, 310A, or 310C) and the second polarization member (314). Therefore, the light intensity distribution becomes uniform over the lens surface especially in the vicinity of pupil surface (PS 1) of projection optical system (313) arranged between first polarization member (310; 310A; 310C) and second polarization member (314). This decreases high order thermal deformation on lens surfaces in the vicinity of pupil surface (PS 1). As a result, fluctuations in high order spherical aberrations in the projection optical system (313) are suppressed. Also, the second polarization member (314) blocks light beams except the imaging beam. Accordingly, this invention provides high resolution on photosensitive substrate.

One of the examples of the first polarization member (310; 310A; 310C) is a device that transmits only a predetermined polarized light out of the exposing illumination light (IL). The exposure illumination light (IL) passes through the inside of the annular shaped region (325; 325A) around the optical axis, or the region (328) excluding a plurality of regions (327A, 327B, 327C; 327D), which are positioned eccentric from the optical axis. If the first polarization member is the member (310; 310C) that selects a predetermined polarization direction in the region excluding the inside of the annular shaped region, this configuration becomes equivalent to the case of using a center-blocked pupil filter or performing the annular illumination method. Also, if the first polarization member is the member (310A) which sets the polarized direction for the regions excluding a plurality of regions which are positioned eccentric with respect to the optical axis, a modified illumination technique will provide the equivalent.

In addition, it is preferable that the driving unit (or system) (321, 322, 323) rotates the first polarization member (310; 310A; 310C) and the second polarization member (314) while maintaining a predetermined relative angular relationship. The first polarization member (310; 310A; 310C) and the second polarization member (314) may be rotated during exposure such that the polarization direction of exposing illumination light which enters photosensitive substrate (315) are rotated. This way, the possibility of generating abnormal deviations of the image line width of the mask pattern, which is generated depending on the periodic direction of a mask pattern on photosensitive substrate (315), can be eliminated. In addition, because the first polarization member (310) and the second polarization member (314) rotate while maintaining the predetermined angular relationship, the beam which is polarized by the first polarization member (310) can be accurately blocked by the second polarization member (314).

In stead of having such driving system (321, 322, 323), a third polarization member may be placed between the second polarization member (314) and the photosensitive substrate (315) such that exposure illumination light (IL) which passes through the second polarization member (314) is converted to circular polarized light. This provides a circular polarized imaging beam illuminating photosensitive substrate (315), thereby reducing the possibility of generating abnormality in line width of a mask pattern in its periodic direction.

It will be apparent to those skilled in the art that various modifications and variations can be made in the projection exposure apparatus of the present invention without departing from the spirit or scope of the invention. Thus, it is intended that the present invention cover the modifications and variations of this invention provided they come within the scope of the appended claims and their equivalents.

## Claims

1. A projection exposure apparatus for transferring the image of a mask pattern on a mask onto a photosensitive substrate by an exposing radiation flux, the projection exposure apparatus comprising:

   a projection optical system including at least one lens and having a predetermined optical axis;
   a first illumination system for directing the exposing radiation flux that is capable of exposing the photosensitive substrate toward the mask to illuminate the mask pattern, the exposing radiation flux that has passed through the mask entering the projection optical system and illuminating the at least one lens, a thus illuminated portion of the at least one lens having rotational asymmetry around the predetermined optical axis, the exposing radiation flux that has passed through the at least one lens exposing the image of the mask pattern onto the photosensitive substrate; and
   a second illumination system for directing a non-exposing radiation flux flux is incapable of exposing the photosensitive substrate toward the projection optical system, the non-exposing radiation flux illuminating the at least one lens in the projection optical system to complement the portion illuminated by the exposing radiation flux such that the resultant illuminated portions on the at least one lens have substantial rotational symmetry around the predetermined optical axis of the projection optical system as a whole.

2. The projection exposure apparatus according to claim 1, wherein the second illumination system directs the non-exposing radiation flux toward at least one of mask alignment mark on the mask and substrate alignment mark on the photosensitive substrate,

   the projection exposure apparatus further comprising a mark position detecting system for photoelectrically detecting the non-exposing radiation flux from the at least one of the mask alignment mark and the substrate alignment mark to derive the position of the at least one of the mask alignment mark and the substrate alignment mark.

3. The projection exposure apparatus according to claim 1, wherein the projected image of said resultant illuminated portions on the at least one lens is substantially coincident with the field of view of the projection optical system at the side of the photosensitive substrate.

4. A projection exposure apparatus for transferring the image of a mask pattern on a mask onto a photosensitive substrate, the projection exposure apparatus comprising:

   a projection optical system for projecting the image of the mask pattern on the mask onto the photosensitive substrate, the projection optical system including at least one lens and having a predetermined, optical axis;
   a first light source for emitting first illumination light that is capable of exposing the photosensitive substrate;
   a second light source for emitting second illumination light that is incapable of exposing the photosensitive substrate;
   a combining system for combining the first illumination light and the second illumination light and directing the combined light toward the mask; and
   a field stop disposed on an optical path between the combining system and the mask at a position substantially conjugate with a patterned surface of the mask, the field stop including a first transmissive portion for selectively transmitting the first illumination light and a second transmissive portion for selectively transmitting the second illumination light, the first illumination light that has passed through the first transmissive portion entering the projection optical system through the mask to illuminate the at least one lens in the projection optical system, a thus illuminated portion of the at least one lens having rotational asymmetry around the predetermined optical axis of the projection optical system, the first illumination light that has passed through the at least one lens exposing the image of the mask pattern onto the photosensitive substrate, the second illumination light that has passed through the second transmissive portion entering the projection optical system through the mask to illuminate the at least one lens to complement the portion illuminated by the first illumination light such that the resultant illuminated portions of the at least one lens have substantial rotational symmetry around the predetermined optical axis of the projection optical system as a whole.

5. The projection exposure apparatus according to claim 4, wherein at least one of mask alignment mark on the mask and substrate alignment mark on the photosensitive substrate are illuminated by the second illumination light,

the projection exposure apparatus further comprising a mark position detecting system for photoelectrically detecting the second illumination light from the at least one of the mask alignment mark and the substrate alignment mark to derive the position of the at least one of the mask alignment mark and the substrate alignment mark.

6. The projection exposure apparatus according to claim 4, wherein the projected image of said resultant illuminated portions on the at least one lens is substantially coincident with the field of view of the projection optical system at the side of the photosensitive substrate.

7. A projection exposure apparatus for transferring the image of a mask pattern on a mask onto a photosensitive substrate by an exposing radiation flux, the projection exposure apparatus comprising:

a projection optical system having a predetermined optical axis, for projecting the image of the mask pattern onto the photosensitive substrate;
an illumination optical system for directing the exposing radiation flux toward the mask, the exposing radiation flux that has passed through the mask entering the projection optical system with a cross-section substantially circular around the predetermined optical axis; and
a light control member disposed between the projection optical system and the photosensitive substrate, the light control member including a transmissive portion for selectively transmitting the exposing radiation flux from the projection optical system, the exposing radiation flux that has passed through the transmissive portion having a cross-section substantially rotationally asymmetric around the predetermined optical axis of the projection optical system.

8. A projection exposure apparatus for projecting the image of a mask pattern on a mask onto a photosensitive substrate by an exposing radiation flux, comprising:

a projection optical system having an optical axis and a pupil surface;
an illumination optical system for directing the exposing radiation flux toward the mask, the exposing radiation flux that has passed through the mask entering the projection optical system and passing through portions on the pupil surface that are distributed to exclude an area including the optical axis of the projection optical system; and
an auxiliary optical system for directing a non-exposing radiation flux that is incapable of exposing the photosensitive substrate toward the remaining portions on the pupil surface excluding the portions which the exposing radiation passes through.

9. The projection exposure apparatus according to claim 8, wherein the illumination optical system includes an optical integrator for making the distribution of the exposing radiation flux uniform, further comprising an auxiliary light input member disposed between the optical integrator and the mask for directing the non-exposing radiation flux from the auxiliary optical system toward the pupil surface of the projection optical system through the mask.

10. The projection exposure apparatus according to claim 8, wherein the illumination optical system includes an annular-shaped light source for illuminating the mask with the exposing radiation flux.

11. The projection exposure apparatus according to claim 10, wherein the illumination optical system includes an optical integrator for making the distribution of the exposing radiation flux uniform, further comprising an auxiliary light input member disposed between the optical integrator and the mask for directing the non-exposing radiation flux from the auxiliary optical system toward the pupil surface of the projection optical system through the

12. The projection exposure apparatus according to claim 8, wherein the illumination optical system includes a plurality of light sources positioned eccentrically with respect to the optical axis for illuminating the mask with the exposing radiation flux.

13. The projection exposure apparatus according to claim 12, wherein the illumination optical system includes an optical integrator for making the distribution of the exposing radiation flux uniform, further comprising an auxiliary light input member disposed between the optical integrator and the mask for directing the non-exposing radiation flux from the auxiliary optical system toward the pupil surface of the projection optical system through the mask.

14. A projection exposure apparatus for projecting the image of a mask pattern on a mask onto a photosensitive substrate by an exposing radiation flux, comprising:

a projection optical system having an optical axis and a pupil surface;
a combining illumination optical system for directing the exposing radiation flux that is capable of exposing the photosensitive substrate and a non-exposing radiation flux that is incapable of exposing the photosensitive substrate toward the pupil surface of the projection optical system, the exposing radiation flux passing through portions on the pupil surface that are distributed to exclude an area including the optical axis of the projection optical system; and
an optical member for selectively directing toward the photosensitive substrate the non-exposing radiation flux that passes through the remaining portions of the pupil surface.

15. The projection exposure apparatus according to claim 14, wherein the portions of the pupil surface, which the exposing radiation flux passes through, are annularly distributed around the optical axis of the projection optical system.

16. The projection exposure apparatus according to claim 15, wherein the portions of the pupil surface, which the exposing radiation flux passes through, are eccentrically distributed with respect to the optical axis of the projection optical system.

17. A projection exposure apparatus using a portion of an exposing radiation flux that is obliquely incident on or obliquely emitted from a mask as effective exposing light to expose a photosensitive substrate, the projection exposure apparatus comprising:

a projection optical system for projecting the image of a mask pattern on the mask onto the photosensitive substrate with the exposing radiation flux, the projection optical system having an pupil surface and an optical axis;
an illumination optical system for illuminating the mask using the exposing radiation flux from a plurality of light sources, which are substantially uniformly distributed over an circular region around the optical axis at a surface conjugate with the pupil surface of the projection optical system;
a first polarization member disposed at at least one of the pupil surface of the projection optical system and a surface conjugate with the pupil surface, the first polarization member polarizing the remaining exposing radiation flux excluding said effective exposing radiation flux in a predetermined direction; and
a second polarization member disposed between the projection optical system and the photosensitive substrate, the second polarization member blocking the exposing radiation flux that has been polarized in the predetermined direction by the first polarization member and passed through the projection optical system.

18. The projection exposure apparatus according to claim 17, further comprising a driving unit for synchronously rotating the first polarization member and the second polarization member around the optical axis while maintaining a predetermined angular relationship therebetween.

19. The projection exposure apparatus according to claim 17, further comprising a third polarization member disposed between the second polarization member and the photosensitive substrate, for converting the exposing radiation flux that has passed through the second polarization member into circular polarized light.

20. The projection exposure apparatus according to claim 17, wherein said effective exposing radiation flux passes through portions of the at least one of the pupil surface and the surface conjugate with the pupil surface that are annulary distributed around the optical axis of the projection optical system.

21. The projection exposure apparatus according to claim 20, further comprising a driving unit for synchronously rotating the first polarization member and the second polarization member around the optical axis while maintaining a predetermined angular relationship therebetween.

22. The projection exposure apparatus according to claim 20, further comprising a third polarization member disposed between the second polarization member and the photosensitive substrate, for converting the exposing radiation flux that has passed through the second polarization member into circular polarized light.

23. The projection exposure apparatus according to claim 17, wherein said effective exposing radiation flux passes portions of the at least one of the pupil surface and the surface conjugate with the pupil surface that are eccentrically distributed with respect to the optical axis of the projection optical system.

24. The projection exposure apparatus according to claim 23, further comprising a driving unit for synchronously rotating the first polarization member and the second polarization member around the optical axis while maintaining a predetermined angular relationship therebetween.

25. The projection exposure apparatus according to claim 23, further comprising a third polarization member disposed between the second polarization member and the photosensitive substrate, for converting the exposing radiation flux that has passed through the second polarization member into circular polarized light.

26. A method of suppressing non-uniform illumination distribution on a lens in a projection optical system used in a projection exposure apparatus for projecting the image of a mask pattern on a mask onto a photosensitive substrate through the projection optical system, the method comprising the steps of:

   directing the exposing radiation flux that is capable of exposing the photosensitive substrate toward the mask;
   guiding the exposing radiation flux that has passed through the mask toward the projection optical system, the exposing radiation flux illuminating a portion on the lens in the projection optical system;
   directing a complementary radiation flux toward the lens to illuminate a substantially remaining portion on the lens; and
   transferring the image of the mask pattern onto the photosensitive substrate with the exposing radiation flux that has illuminated the portion of the lens in the step of guiding.

27. The method according to claim 26, wherein the step of directing the complementary radiation flux includes directing a non-exposing radiation flux that is incapable of exposing the photosensitive substrate.

28. The method according to claim 27, wherein the step of directing the complementary radiation flux includes directing the exposing radiation flux toward the lens to illuminate the substantially remaining portion on the lens,

   the method further comprising, between the step of directing the complementary radiation flux and the step of transferring, the step of blocking the exposing radiation flux that has illuminated the substantially remaining portion of the lens in the step of directing the complementary radiation flux.

29. A method for fabricating one of semiconductor device, liquid crystal device, image pick up device and thin film magnetic head by using the projection exposure apparatus according to claim 1, the method comprising the steps of:

   illuminating said mask with said exposing radiation flux;
   projecting said image of the mask pattern onto said photosensitive substrate through said projection optical system, thereby performing an exposure process.

30. A method for fabricating one of semiconductor device, liquid crystal device, image pick up device and thin film magnetic head by using the projection exposure apparatus according to claim 4, the method comprising the steps of:

   illuminating said mask with said first illumination light;
   projecting said image of the mask pattern onto said photosensitive substrate through said projection optical system, thereby performing an exposure process.

**31.** A method for fabricating one of semiconductor device, liquid crystal device, image pick up device and thin film magnetic head by using the projection exposure apparatus according to claim 7, the method comprising the steps of:

     illuminating said mask with said exposing radiation flux;
     projecting said image of the mask pattern onto said photosensitive substrate through said projection optical system, thereby performing an exposure process.

**32.** A method for fabricating one of semiconductor device, liquid crystal device, image pick up device and thin film magnetic head by using file projection exposure apparatus according to claim 8, the method comprising the steps of:

     illuminating said mask with said exposing radiation flux;
     projecting said image of the mask pattern onto said photosensitive substrate through said projection optical system, thereby performing an exposure process.

**33.** A method for fabricating one of semiconductor device, liquid crystal device, image pick up device and thin film magnetic head by using the projection exposure apparatus according to claim 14, the method comprising the steps of:

     illuminating said mask with said exposing radiation flux;
     projecting said image of the mask pattern onto said photosensitive substrate through said projection optical system, thereby performing an exposure process.

**34.** A method for fabricating one of semiconductor device, liquid crystal device, image pick up device and thin film magnetic head by using the projection exposure apparatus according to claim 17, the method comprising the steps of:

     illuminating said mask with said exposing radiation flux;
     projecting said image of the mask pattern onto said photosensitive substrate through said projection optical system, thereby performing an exposure process.

FIG. 1A

FIG. 1B

FIG. 1C

FIG. 2A

FIG. 2B

FIG. 2C

FIG. 3A

FIG. 3B

FIG. 4A

FIG. 4B

FIG. 5A

FIG. 5B

FIG. 6A

FIG. 6B

FIG. 7A

FIG. 7B

*FIG. 8A*

*FIG. 8B*

*FIG. 9A*

*FIG. 9B*

FIG. 10

FIG. 11A

FIG. 11B

FIG. 11C

FIG. 12A

FIG. 12B

EP 0 823 662 A2

FIG. 13

FIG. 14A

FIG. 14B

FIG. 21

FIG. 15

FIG. 16

FIG. 17A

FIG. 17B

FIG. 17C

FIG. 18

FIG. 19A

FIG. 19B

FIG. 19C

FIG. 20A

FIG. 20B

FIG. 20C